(19) Europäisches Patentamt
European Patent Office
Office européen des brevets

(11) EP 2 390 938 A1

(12) **EUROPEAN PATENT APPLICATION**
published in accordance with Art. 153(4) EPC

(43) Date of publication:
**30.11.2011 Bulletin 2011/48**

(21) Application number: **10837285.5**

(22) Date of filing: **15.12.2010**

(51) Int Cl.:
***H01L 51/50*** (2006.01) ***C09K 11/06*** (2006.01)

(86) International application number:
**PCT/JP2010/007271**

(87) International publication number:
**WO 2011/074254 (23.06.2011 Gazette 2011/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.12.2009 JP 2009285002**

(71) Applicant: **Idemitsu Kosan Co., Ltd.**
**Chiyoda-ku**
**Tokyo 100-8321 (JP)**

(72) Inventors:
- **KAWAMURA, Masahiro**
**Sodegaura-shi**
**Chiba 299-0293 (JP)**
- **MIZUKI, Yumiko**
**Sodegaura-shi**
**Chiba 299-0293 (JP)**
- **KAWAMURA, Yuichiro**
**Sodegaura-shi**
**Chiba 299-0293 (JP)**
- **SAITO, Hiroyuki**
**Sodegaura-shi**
**Chiba 299-0293 (JP)**

(74) Representative: **Gille Hrabal Struck Neidlein Prop Roos**
**Patentanwälte**
**Brucknerstrasse 20**
**40593 Düsseldorf (DE)**

(54) **ORGANIC LUMINESCENT MEDIUM**

(57) An organic luminescent medium including an anthracene derivative represented by the following formula (1) and a compound having at least one electron-attracting group in the molecular structure thereof.

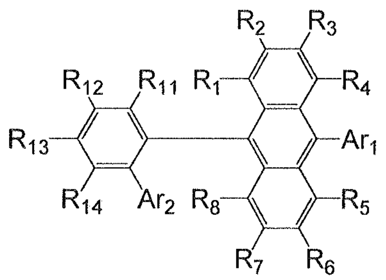

(1)

EP 2 390 938 A1

## Description

TECHNICAL FIELD

The invention relates to an organic luminescent medium and an organic electroluminescence device.

BACKGROUND ART

An organic electroluminescence (EL) device using an organic substance is a promising solid-state emitting type inexpensive and large full-color display device, and has been extensively developed. In general, an organic EL device includes an emitting layer and a pair of opposing electrodes holding the emitting layer therebetween. When an electric field is applied between the electrodes, electrons are injected from the cathode and holes are injected from the anode. Emission is a phenomenon in which the electrons recombine with the holes in the emitting layer to produce an excited state, and energy is emitted as light when the excited state returns to the ground state.

The performance of an organic EL device has been gradually improved with improvements in emitting materials for an organic EL device. In particular, improvement in color purity (shortening of emission wavelength) of a blue-emitting organic EL device is an important factor leading to high color reproducibility of a display.

As examples of a material for an emitting layer, Patent Documents 1 to 3 disclose a doping material which is substituted by an electron-attracting group. An organic EL device using such a doping material can emit pure blue light. However, the lifetime properties thereof is required to be further improved. Patent Documents 4 and 5 each disclose, as a host material, some compounds each having a substituent at the ortho position. However, an organic EL device using such a host material is required to be further improved in lifetime properties.

Related Art Documents

Patent Documents

Patent Document 1: Korean Patent Publication No. 10-2007-0115588

Patent Document 2: Korean Patent Publication No. 10-2008-0079956

Patent Document 3: WO2008/102740

Patent Document 4: WO2005/054162

Patent Document 5: WO2004/018587

DISCLOSURE OF THE INVENTION

An object of the invention is to provide an organic luminescent medium which realizes an organic EL device which can emit blue light which is high in color purity and has a long lifetime.

According to the invention, the following organic luminous medium or the like are provided.

1. An organic luminescent medium comprising an anthracene derivative represented by the following formula (1) and a compound having at least one electron-attracting group in the molecular structure thereof:

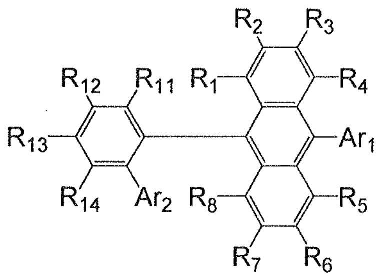

(1)

wherein $R_1$ to $R_8$ and $R_{11}$ to $R_{14}$ are independently a hydrogen atom, a fluorine atom, a substituted or unsubstituted alkyl group having 1 to 10 carbon atoms, a substituted or unsubstituted cycloalkyl group having 3 to 10 carbon atoms that form a ring (hereinafter referred to as "ring carbon atoms"), a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 atoms that form a ring (hereinafter referred to as "ring atoms"), and $Ar_1$ and $Ar_2$ are independently a substituted or unsubstituted aryl group having 6 to 30 ring carbon atoms or a substituted or unsubstituted heterocyclic group having 5 to 30 ring atoms.

2. The organic luminescent medium according to 1 wherein the compound having at least one electron-attracting group is a compound represented by the following formula (2):

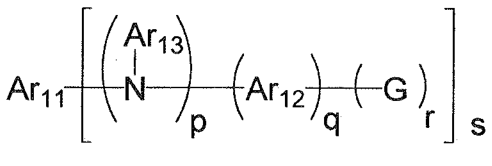

(2)

wherein $Ar_{11}$ is a substituted or unsubstituted anthracene-containing group, a substituted or unsubstituted pyrene-containing group, a substituted or unsubstituted chrysene-containing group, a substituted or unsubstituted benzofluoranthene-containing group or a substituted or unsubstituted styryl-containing group,
$Ar_{12}$ and $Ar_{13}$ are independently a substituted or unsubstituted aryl group having 6 to 30 ring carbon atoms or a substituted or unsubstituted heterocyclic group having 5 to 30 ring atoms,
G is an electron-attracting group,
p and q are independently an integer of 0 or 1, r is an integer of 1 to 5 and s is an integer of 1 to 6, and if p and q are 0, r is 1, and if p is 1, q is 1.

3. The organic luminescent medium according to 2 wherein the compound represented by the formula (2) is one of the compounds represented by the following formulas (3) to (8):

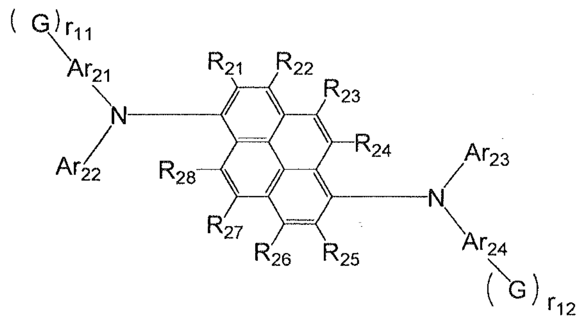

(3)

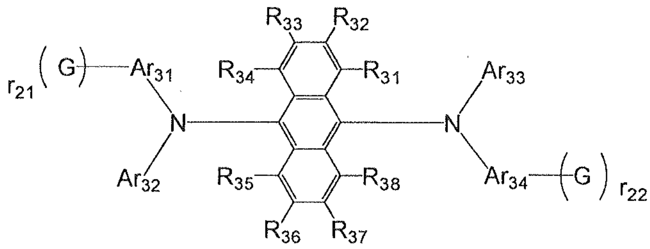

(4)

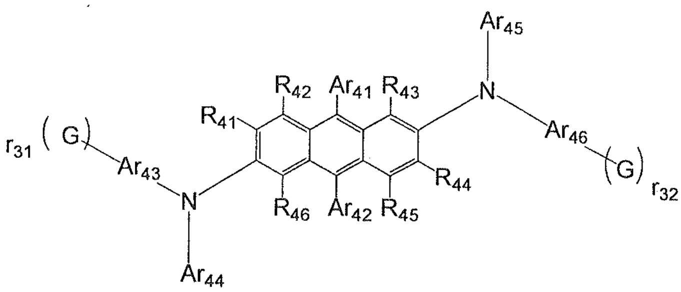

(5)

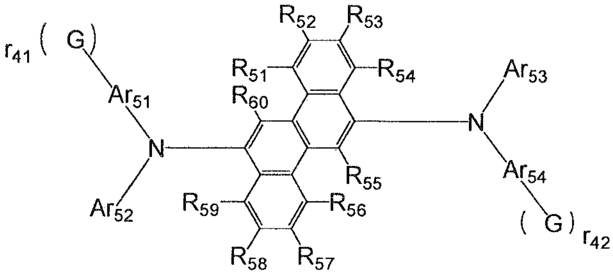

(6)

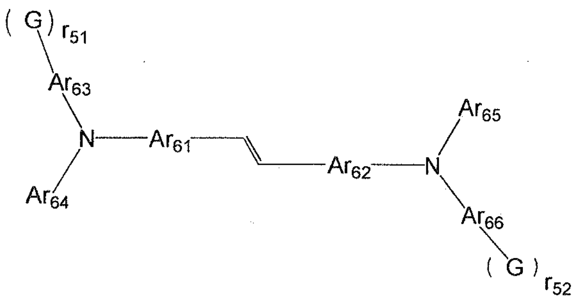

(7)

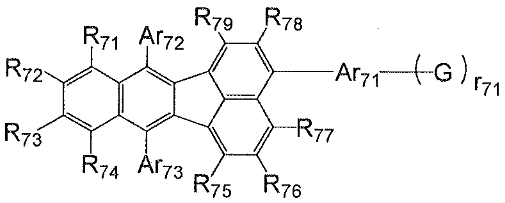

(8)

wherein $R_{21}$ to $R_{28}$, $R_{31}$ to $R_{38}$, $R_{41}$ to $R_{46}$, $R_{51}$ to $R_{60}$ and $R_{71}$ to $R_{79}$ are independently a hydrogen atom, a fluorine

atom, a substituted or unsubstituted alkyl group having 1 to 10 carbon atoms, a substituted or unsubstituted cycloalkyl group having 3 to 10 ring carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,

$Ar_{21}$ to $Ar_{24}$, $Ar_{31}$ to $Ar_{34}$, $Ar_{41}$ to $Ar_{46}$, $Ar_{51}$ to $Ar_{54}$, $Ar_{61}$ to $Ar_{66}$, and $Ar_{71}$ to $Ar_{73}$ are independently a substituted or unsubstituted aryl group having 6 to 30 ring carbon atoms or a substituted or unsubstituted heterocyclic group having 5 to 30 ring atoms,

G is an electron-attracting group,

$r_{11}$, $r_{12}$, $r_{21}$, $r_{22}$, $r_{31}$, $r_{32}$, $r_{41}$, $r_{42}$, $r_{51}$, $r_{52}$ and $r_{71}$ are independently an integer of 1 to 5, and when two or more Gs are in one compound, they may be the same or different.

4. The organic luminescent medium according to any one of 1 to 3 wherein the electron-attracting group is a cyano group.

5. The organic luminescent medium according to any one of 1 to 4 wherein $Ar_1$ in the anthracene derivative represented by the formula (1) is a fused aromatic ring group having 10 to 30 ring carbon atoms.

6. The organic luminescent medium according to any one of 1 to 4 wherein the anthracene derivative represented by the formula (1) is represented by the following formula (10):

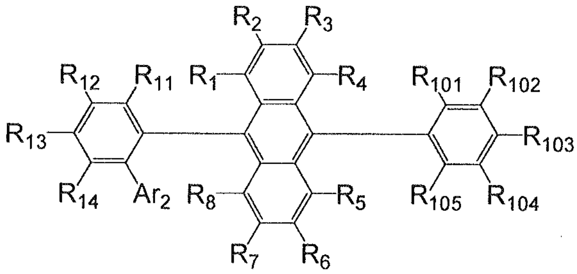

(10)

wherein $R_1$ to $R_8$, $R_{11}$ to $R_{14}$ and $Ar_2$ are the same as defined in 1, and $R_{101}$ to $R_{105}$ are independently a hydrogen atom, a fluorine atom, a substituted or unsubstituted alkyl group having 1 to 10 carbon atoms, a substituted or unsubstituted cycloalkyl group having 3 to 10 ring carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms.

7. The organic luminescent medium according to 6 wherein the anthracene derivative represented by the formula (1) is represented by the following formula (11):

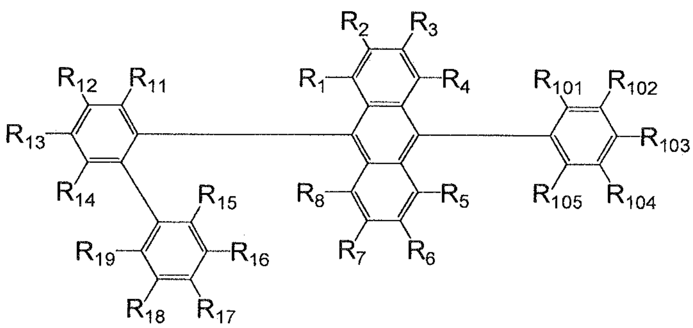

(11)

wherein $R_1$ to $R_8$, $R_{11}$ to $R_{14}$ and $R_{101}$ to $R_{105}$ are the same as defined in 6, and

$R_{15}$ to $R_{19}$ are independently a hydrogen atom, a fluorine atom, a substituted or unsubstituted alkyl group having 1 to 10 carbon atoms, a substituted or unsubstituted cycloalkyl group having 3 to 10 ring carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted

or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms.

8. The organic luminescent medium according to 6 or 7 wherein one of $R_{101}$ to $R_{105}$ is a substituted or unsubstituted aryl group having 6 to 30 ring carbon atoms or a substituted or unsubstituted heterocyclic group having 5 to 30 ring atoms, and the remaining $R_{101}$ to $R_{105}$ are all hydrogen atoms.

9. An organic thin film comprising the organic luminescent medium according to any one of 1 to 8.

10. An organic electroluminescence device comprising one or more organic thin film layers comprising at least an emitting layer between an anode and a cathode wherein at least one layer of the organic thin film layers is the organic thin film according to 9.

According to the invention, an organic luminescent medium which can emit blue light which is high in color purity and has a long lifetime can be provided.

MODE FOR CARRYING OUT THE INVENTION

The organic luminescent medium of the invention comprises an anthracene derivative represented by the following formula (1) and a compound having at least one electron-attracting group in the molecular structure thereof.

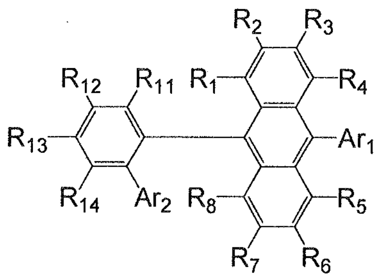

(1)

In the formula, $R_1$ to $R_8$ and $R_{11}$ to $R_{14}$ are independently a hydrogen atom, a fluorine atom, a substituted or unsubstituted alkyl group having 1 to 10 carbon atoms, a substituted or unsubstituted cycloalkyl group having 3 to 10 ring carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms, and

$Ar_1$ and $Ar_2$ are independently a substituted or unsubstituted aryl group having 6 to 30 ring carbon atoms or a substituted or unsubstituted heterocyclic group having 5 to 30 ring atoms.

The material of the invention can improve the luminous lifetime by using in combination an anthracene derivative represented by the formula (1) and a compound having at least one electron-attracting group in the molecular structure.

In the anthracene derivative represented by the formula (1), it is preferred that $Ar_1$ be a fused aromatic ring group having 10 to 30 ring carbon atoms.

Further, an anthracene derivative represented by the following formula (10) is preferable.

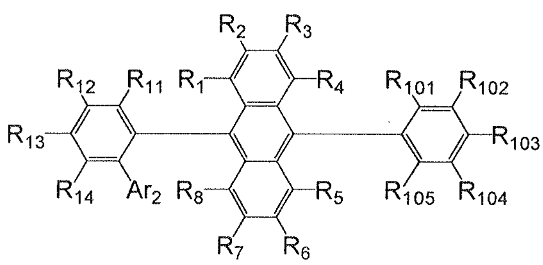

(10)

In the formula, $R_1$ to $R_8$, $R_{11}$ to $R_{14}$ and $Ar_2$ are the same as those in the formula (1).

$R_{101}$ to $R_{105}$ are independently a hydrogen atom, a fluorine atom, a substituted or unsubstituted alkyl group having 1 to

10 carbon atoms, a substituted or unsubstituted cycloalkyl group having 3 to 10 ring carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms.

In particular, an anthracene derivative represented by the following formula (11) is preferable.

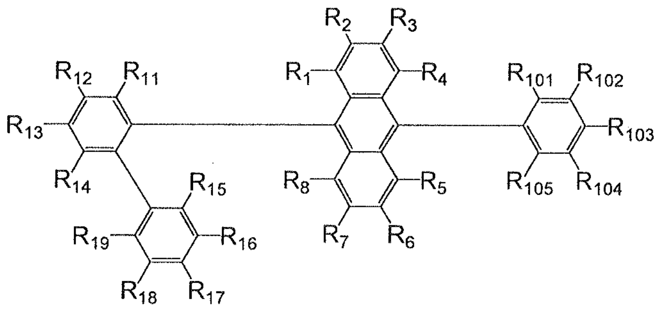

(11)

In the formula, $R_1$ to $R_8$, $R_{11}$ to $R_{14}$ and $R_{101}$ to $R_{105}$ are the same as those in the formula (10).
$R_{15}$ to $R_{19}$ are independently a hydrogen atom, a fluorine atom, a substituted or unsubstituted alkyl group having 1 to 10 carbon atoms, a substituted or unsubstituted cycloalkyl group having 3 to 10 ring carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms.

Further, it is preferred that one of $R_{101}$ to $R_{105}$ be a substituted or unsubstituted aryl group having 6 to 30 ring carbon atoms or a substituted or unsubstituted heterocyclic group having 5 to 30 ring atoms, and that the remaining $R_{101}$ to $R_{105}$ be all hydrogen atoms.

In this specification, the "ring carbon" means a carbon atom which constitutes a saturated ring, an unsaturated ring or an aromatic ring. The "ring atom" means a carbon atom or a hetero atom which constitutes a hetero ring (including a saturated ring, an unsaturated ring and an aromatic ring).
Examples of substituents in "substituted or unsubstituted..." include an alkyl group, an alkylsilyl group, a halogenated alkyl group, an aryl group, a cycloalkyl group, an alkoxy group, a heterocyclic group, an aralkyl group, an aryloxy group, an arylthio group, an alkoxycarbonyl group, a halogen atom, a hydroxyl group, a nitro group, a cyano group, a carboxy group, a dibenzofuranyl group and a fluorenyl group, as described below.
The hydrogen atom of the invention includes light hydrogen and deuterium.
Specific examples of the groups in each of the above-mentioned formulas, and the substituents are shown below.

Examples of the aryl group having 6 to 30 ring carbon atoms include a phenyl group, a naphthyl group, an anthryl group, a phenanthryl group, a naphthacenyl group, a pyrenyl group, a chrysenyl group, a benzo[c]phenanthryl group, a benzo[g]chrysenyl group, a triphenylenyl group, a fluorenyl group, a 9,9-dimethylfluorene-2-yl group, a benzofluorenyl group, a dibenzofluorenyl group, a biphenylyl group, a terphenylyl group, a tolyl group, a p-t-butylphenyl group, a p-(2-phenylpropyl)phenyl group, a 3-methyl-2-naphthyl group, a 4-methyl-1-naphthyl group, a 4-methyl-1-anthryl group, a 4'-methylbiphenylyl group and a 4"-t-butyl-p-terphenyl-4-yl group.

The aryl group having 6 to 30 ring carbon atoms is preferably an unsubstituted phenyl group, a substituted phenyl group, a substituted or unsubstituted aryl group having 10 to 14 ring carbon atoms (1-naphthyl group, 2-naphthyl group, 9-phenanthryl group, for example), a substituted or unsubstituted fluorenyl group (2-fluorenyl group) and a substituted or unsubstituted pyrenyl group (1-pyrenyl group, 2-pyrenyl group, 4-pyrenyl group).
The aryl group having 6 to 30 ring carbon atoms is preferably an aryl group having 6 to 20 ring carbon atoms, more preferably 6 to 14 ring carbon atoms, and particularly preferably 6 to 10 ring carbon atoms.
The aryl group having 6 to 30 ring carbon atoms may be substituted by a substituent such as an alkyl group, a cycloalkyl group, an aryl group and a heterocyclic group. As examples of the substituent, the same groups as the substituents mentioned above can be given. As the substituent, an aryl group and a heterocylic group are preferable.

As the heterocyclic group having 5 to 30 ring atoms, a pyrrolyl group, a pyrazinyl group, a pyridinyl group, an indolyl group, an isoindolyl group, a furyl group, a benzofuranyl group, an isobenzofuranyl group, a dibenzofuranyl group, a dibenzothiophenyl group, a quinolyl group, an isoquinolyl group, a quinoxalinyl group, a carbazolyl group, a phenanthrydinyl group, an acridinyl group, a phenanthronyl group, a phenothiazinyl group, a phenoxazinyl group, an oxazolyl group, an oxadiazolyl group, a furazanyl group, a thienyl group, a 2-methylpyrrolyl group, a 3-methylpyrrolyl group, a 2-t-butylpyrrolyl group, a 3-(2-phenylpropyl)pyrrolyl group, or the like can be given. Of these, a dibenzofuranyl group, a dibenzothiophenyl group and a carbazolyl group are preferable. The heterocyclic group having 5 to 30 ring atoms is preferably a heterocyclic group having 5 to 20 ring atoms, more preferably a heterocyclic group having 5 to 14 ring atoms.

The heterocyclic group having 5 to 30 ring atoms may be substituted by a substituent such as an alkyl group, a cycloalkyl group, an aryl group and a heterocyclic group, and examples of the substituent include the same groups as the above-mentioned substituents. As the substituent, an aryl group and a heterocyclic group are preferable.

Examples of the alkyl group having 1 to 10 carbon atoms include a methyl group, an ethyl group, a propyl group, an isopropyl group, an n-butyl group, an s-butyl group, an isobutyl group, a t-butyl group, an n-pentyl group, an n-hexyl group, an n-heptyl group, an n-octyl group, a hydroxymethyl group, a 1-hydroxyethyl group, a 2-hydroxyethyl group, a 2-hydroxyisobutyl group, a 1,2-dihydroxyethyl group, a 1,3-dihydroxyisopropyl group, a 2,3-dihydroxy-t-butyl group, a 1,2,3-trihydroxypropyl group, an aminomethyl group, a 1-aminoethyl group, a 2-aminoethyl group, a 2-aminoisobutyl group, a 1,2-diaminoethyl group, a 1,3-diaminoisopropyl group, a 2,3-diamino-t-butyl group, a 1,2,3-triaminopropyl group, a cyanomethyl group, a 1-cyanoethyl group, a 2-cyanoethyl group, a 2-cyanoisobutyl group, a 1,2-dicyanoethyl group, a 1,3-dicyanoisopropyl group, a 2,3-dicyano-t-butyl group and a 1,2,3-tricyanopropyl group.

The alkyl group having 1 to 10 carbon atoms is preferably an alkyl group having 1 to 8 carbon atoms, more preferably an alkyl group having 1 to 6 carbon atoms.

Examples of the alkyl group having 1 to 10 carbon atoms include a methyl group, an ethyl group, a propyl group, an isopropyl group, an n-butyl group, an s-butyl group, an isobutyl group and a t-butyl group. The alkyl group having 1 to 10 carbon atoms may be substituted by a substituent such as an alkyl group, a cycloalkyl group, an aryl group and a heterocyclic group. Examples of the substituent are the same as the substituents mentioned above. As the substituent, an aryl group and a heterocyclic group are preferable.

Examples of the cycloalkyl group having 3 to 10 ring carbon atoms include a cyclopropyl group, a cyclobutyl group, a cyclopentyl group, a cyclohexyl group, a 4-methylcyclohexyl group, a 1-adamantyl group, a 2-adamantyl group, a 1-norbornyl group and a 2-norbornyl group. Of these, a cyclopentyl group and a cyclohexyl group are preferable. As the cycloalkyl group having 3 to 10 ring carbon atoms, a cycloalkyl group having 3 to 8 ring carbon atoms is preferable, with a cycloalkyl group having 3 to 6 ring carbon atoms being more preferable. The cycloalkyl group having 3 to 10 ring carbon atoms may be substituted by a substituent such as an alkyl group, a cycloalkyl group, an aryl group and a heterocyclic group, and examples of the substituent include the same groups as the above-mentioned substituents. As the substituent, an aryl group and a heterocyclic group are preferable.

Examples of the alkylsilyl group or the arylsilyl group include a trimethylsilyl group, a triethylsilyl group, a t-butyldimethylsilyl group, a vinyldimethylsilyl group, a propyldimethylsilyl group and a triphenylsilyl group. The silyl group may be substituted by a substituent such as an alkyl group, cycloalkyl group, an aryl group and a heterocyclic group, and examples of the substituent include the same groups as the above-mentioned substituents. As the substituent, an aryl group and a heterocyclic group are preferable.

The alkoxy group having 1 to 20 carbon atoms is a group represented by -OZ, and Z is selected from the substituted or unsubstituted alkyl group. The alkyl group may be substituted by a substituent such as an alkyl group, a cycloalkyl group, an aryl group and a heterocyclic group, and examples of the substituent include the same groups as the above-mentioned substituents. As the substituent, an aryl group and a heterocyclic group are preferable.

The aryloxy group having 6 to 20 carbon atoms is a group represented by -OZ, and Z is selected from the substituted or unsubstituted aryl group. The aryl group may be substituted by a substituent such as an alkyl group, a cycloalkyl group, an aryl group and a heterocyclic group, and examples of the substituent include the same groups as the above-mentioned substituents. As the substituent, an aryl group and a heterocyclic group are preferable.

Specific examples of the anthracene derivative represented by the formula (1) can be given as follows:

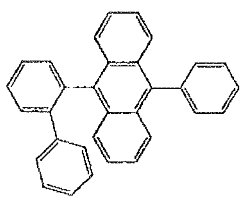 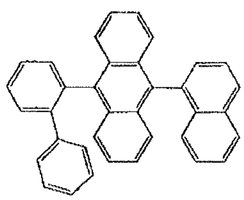 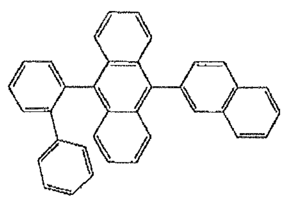

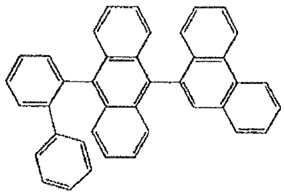 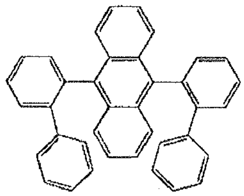 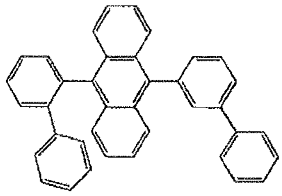

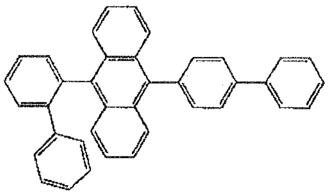 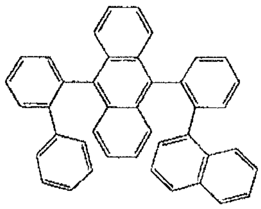 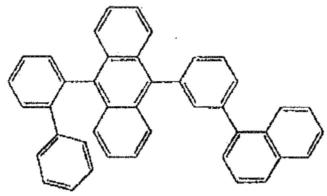

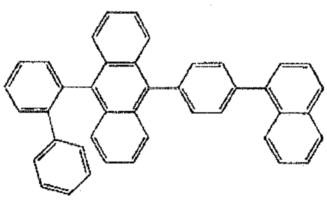 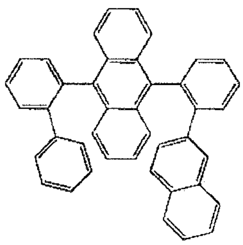 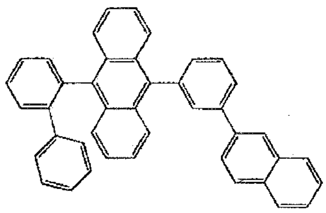

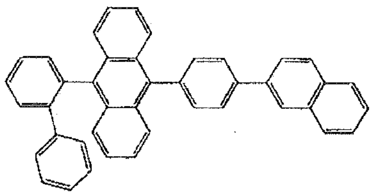 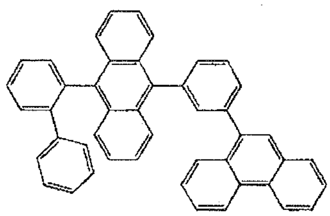

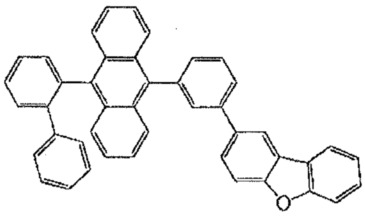 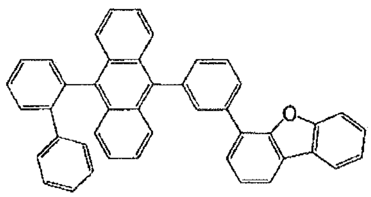

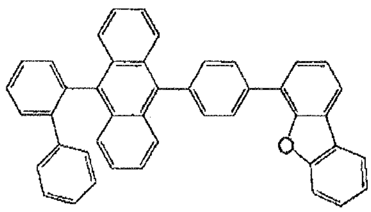

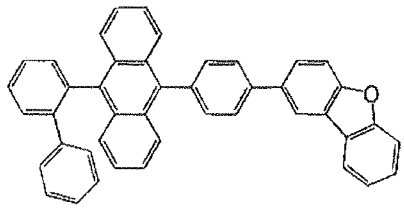

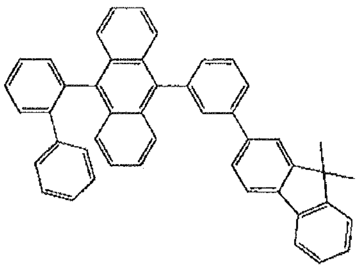

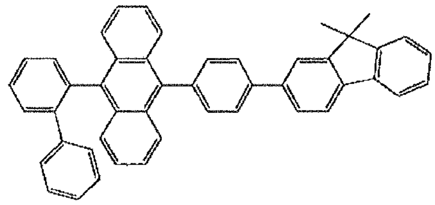

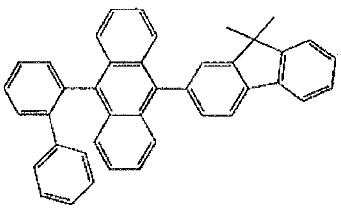

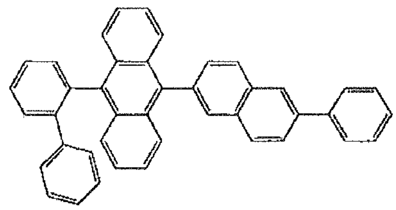

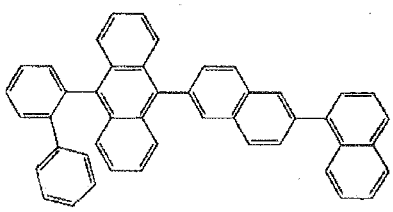

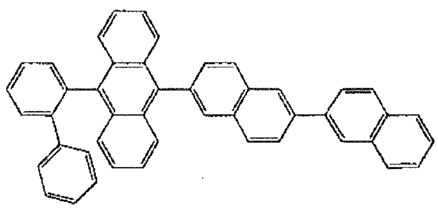

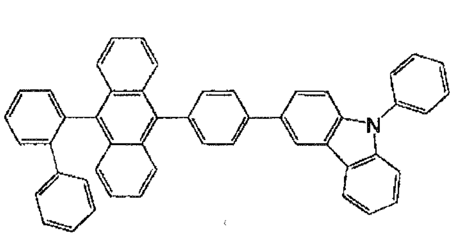

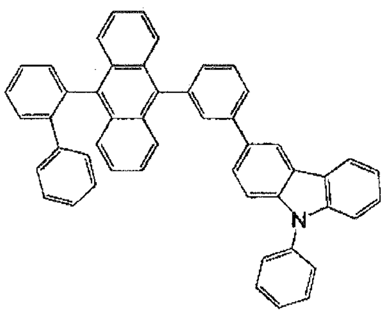

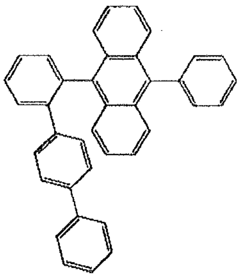
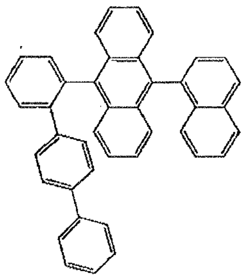
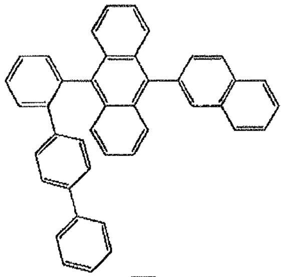

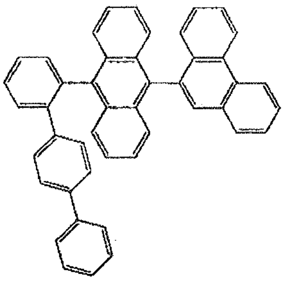
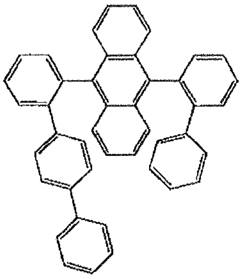
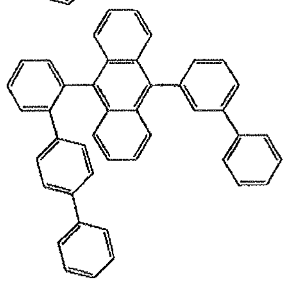

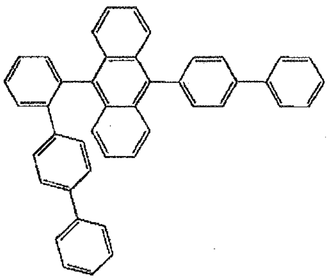
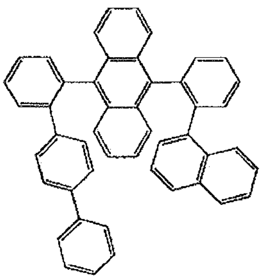
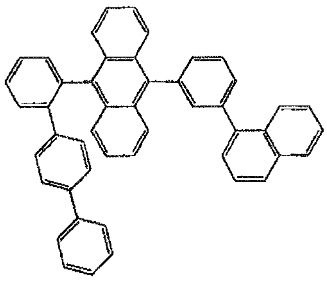

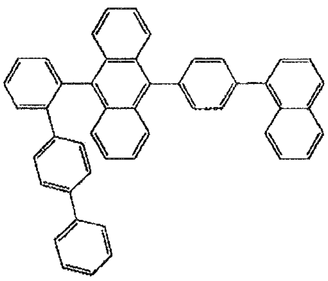
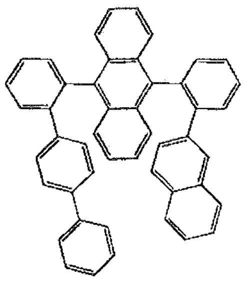
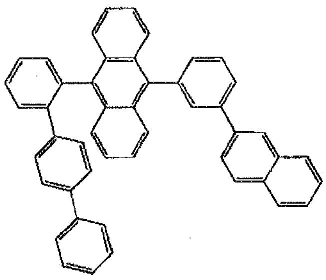

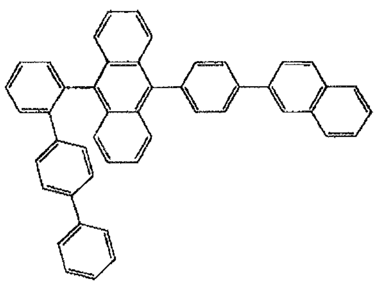
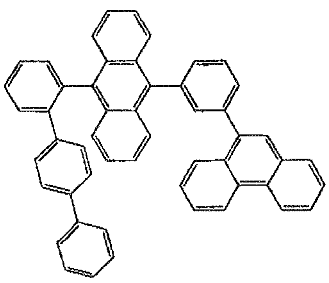

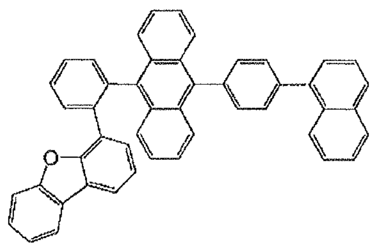
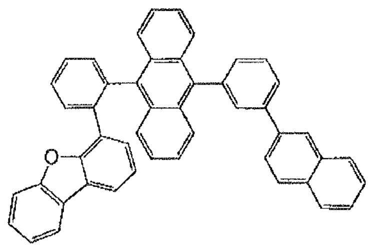
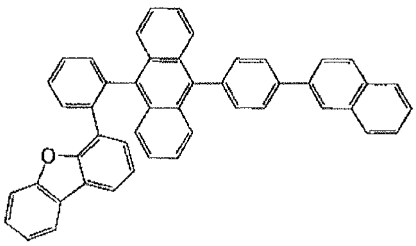
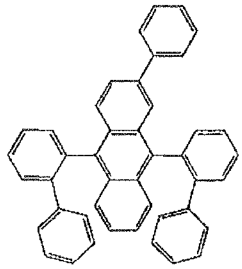
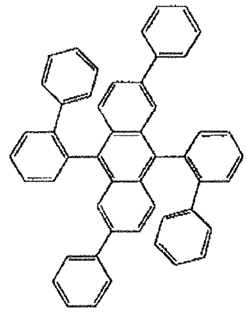
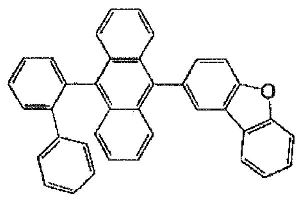
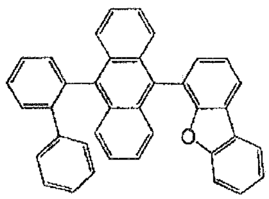
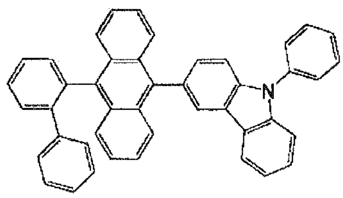
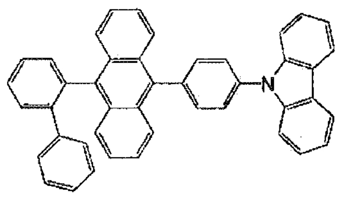

As the compound having at least one electron-attracting group in the molecular structure, a compound represented by the following formula (2) can preferably be given.

$$Ar_{11}\left[\left(\underset{}{\overset{Ar_{13}}{\overset{|}{N}}}\right)_p\left(Ar_{12}\right)_q\left(G\right)_r\right]_s \quad (2)$$

In the formula, $Ar_{11}$ is a substituted or unsubstituted anthracene-containing group, a substituted or unsubstituted pyrene-containing group, a substituted or unsubstituted chrysene-containing group, a substituted or unsubstituted benzofluoranthene-containing group or a substituted or unsubstituted styryl-containing group,
$Ar_{12}$ and $Ar_{13}$ are independently a substituted or unsubstituted aryl group having 6 to 30 ring carbon atoms or a substituted or unsubstituted heterocyclic group having 5 to 30 ring atoms,
G is an electron-attracting group,
p and q are independently an integer of 0 or 1, r is an integer of 1 to 5 and s is an integer of 1 to 6, and
if p and q are 0, r is 1, and if p is 1, q is 1.

Meanwhile, the substituted or unsubstituted aryl group having 6 to 30 ring carbon atoms and the substituted or unsubstituted heterocyclic group having 5 to 30 ring atoms of $Ar_{12}$ are respectively a corresponding residue having 1 + r valencies.

The electron-attracting group is a group having a function of decreasing the electron density. Examples of the electron-attracting group include a cyano group, fluorine, a halogenated alkyl group, a halogenated alkyl-substituted alkyl group, a nitro group and a carbonyl group. Of these, a cyano group, fluorine, a halogenated alkyl group and a halogenated alkyl-substituted alkyl group are preferable, with a cyano group being particularly preferable. Due to the presence of these electron-attracting groups, excessive electrons are trapped and electrons are prevented from entering a hole-transporting material. As a result, deterioration of a hole-transporting material can be prevented, whereby an organic EL device has a prolonged lifetime.

The anthracene-containing group is a group having an anthracene skeleton within the molecule.
The pyrene-containing group is a group having a pyrene skeleton within the molecule.
The chrysene-containing group is a group having a chrysene skeleton within the molecule.
The benzofluoranthene-containing group is a group having a benzofluoranthene skeleton within the molecule.
The styryl-containing group is a group having a styryl skeleton within the molecule.

In the invention, the compound represented by the formula (2) is preferably represented by the formulas (3) to (8).

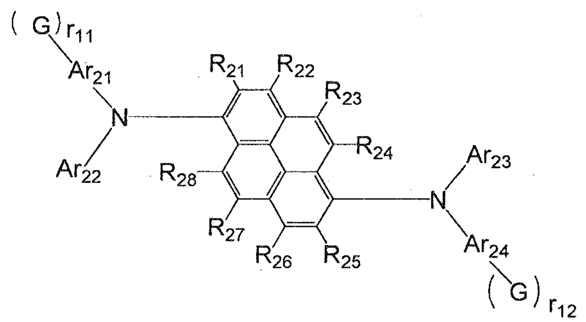

(3)

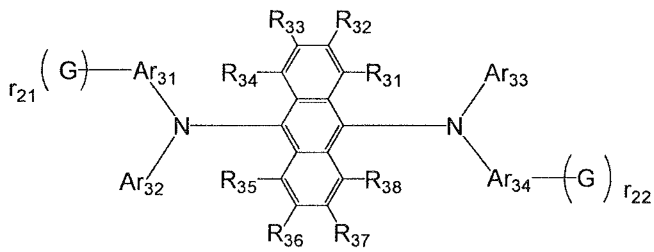

(4)

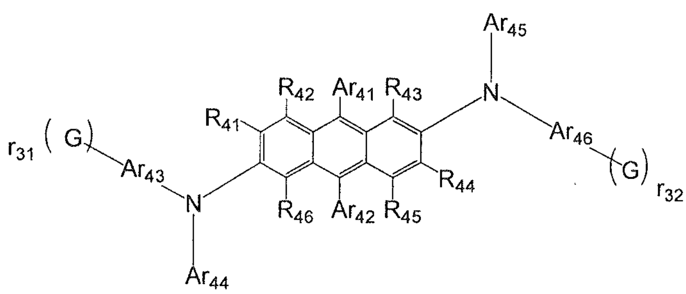

(5)

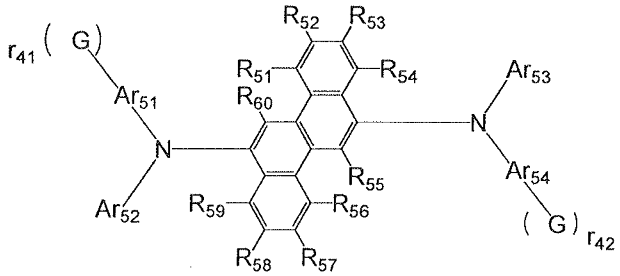

(6)

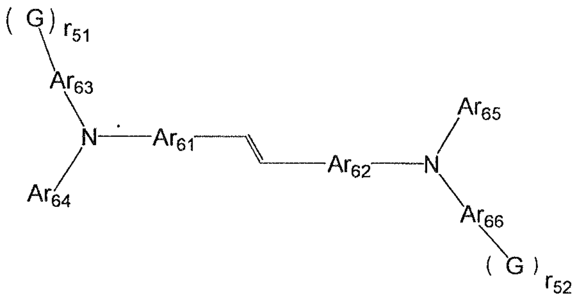

(7)

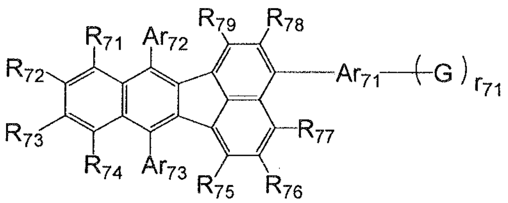

(8)

In the formula, $R_{21}$ to $R_{28}$, $R_{31}$ to $R_{38}$, $R_{41}$ to $R_{46}$, $R_{51}$ to $R_{60}$ and $R_{71}$ to $R_{79}$ are independently a hydrogen atom, a fluorine atom, a substituted or unsubstituted alkyl group having 1 to 10 carbon atoms, a substituted or unsubstituted cycloalkyl group having 3 to 10 ring carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,

$Ar_{21}$ to $Ar_{24}$, $Ar_{31}$ to $Ar_{34}$, $Ar_{41}$ to $Ar_{46}$, $Ar_{51}$ to $Ar_{54}$, $Ar_{61}$ to $Ar_{66}$, and $Ar_{71}$ to $Ar_{73}$ are independently a substituted or unsubstituted aryl group having 6 to 30 ring carbon atoms or a substituted or unsubstituted heterocyclic group having 5 to 30 ring atoms,

G is an electron-attracting group,

$r_{11}$, $r_{12}$, $r_{21}$, $r_{22}$, $r_{31}$. $r_{32}$, $r_{41}$, $r_{42}$, $r_{51}$, $r_{52}$ and $r_{71}$ are independently an integer of 1 to 5, and when two or more Gs are in one compound, they may be the same or different.

The substituted or unsubstituted aryl group having 6 to 30 ring carbon atoms and the substituted or unsubstituted heterocyclic group of $Ar_{21}$ are respectively a corresponding residue having 1 + $r_{11}$ valencies. Similarly, the aryl group and the heterocyclic group of $Ar_{24}$ are respectively a corresponding residue having 1 + $r_{12}$ valencies. The aryl group and the heterocyclic group of $Ar_{31}$ are respectively a corresponding residue having 1 + $r_{21}$ valencies. The aryl group and the heterocyclic group of $Ar_{34}$ are respectively a corresponding residue having 1 + $r_{22}$ valencies. The aryl group and the heterocyclic group of $Ar_{43}$ are respectively a corresponding residue having 1 + $r_{31}$ valencies. The aryl group and the heterocyclic group of $Ar_{46}$ are respectively a corresponding residue having 1 + $r_{32}$ valencies. The aryl group and the heterocyclic group of $Ar_{51}$ are respectively a corresponding residue having 1 + $r_{41}$ valencies. The aryl group and the heterocyclic group of $Ar_{54}$ are respectively a corresponding residue having 1 + $r_{42}$ valencies. The aryl group and the heterocyclic group of $Ar_{63}$ are respectively a corresponding residue having 1 + $r_{51}$ valencies. The aryl group and the heterocyclic group of $Ar_{66}$ are respectively a corresponding residue having 1 + $r_{52}$ valencies. The aryl group

and the heterocyclic group of $Ar_{71}$ are respectively a corresponding residue having 1 + $r_{71}$ valencies.
The substituted or unsubstituted aryl group having 6 to 30 ring carbon atoms and the substituted or unsubstituted heterocyclic group having 5 to 30 ring atoms of $Ar_{61}$ and $Ar_{62}$ are respectively a corresponding divalent residue.
Specific examples of the groups represented by the formulas (2) to (8), and the substitutents thereof are given below.

Examples of the alkyl group include a methyl group, an ethyl group, a propyl group, an isopropyl group, an n-butyl group, an s-butyl group, an isobutyl group, a t-butyl group, an n-pentyl group, an n-hexyl group, an n-heptyl group and an n-octyl group.
It is preferred that the alkyl group have 1 to 10 carbon atoms, more preferably 1 to 8 carbon atoms, and particularly preferably 1 to 6 carbon atoms. Of these, a methyl group, a propyl group, an ethyl group, an isopropyl group, an n-butyl group, an s-butyl group, an isobutyl group, a t-butyl group, an n-pentyl group and an n-hexyl group are preferable.

The alkylsilyl group is represented by $-SiY_3$, and as examples of Y, the same examples as those for the alkyl group mentioned above can be given.

As the aryl group, a phenyl group, a naphthyl group, an anthryl group, a phenanthryl group, a naphthacenyl group, a pyrenyl group, a chrysenyl group, a benzo[c]phenanthryl group, a benzo[g]chryseny group, a triphenylenyl group, a fluorenyl group, a benzofluorenyl group, a dibenzofluorenyl group, a biphenylyl group and a terphenylyl group can be given.
The aryl group has preferably 6 to 20 ring carbon atoms, more preferably 6 to 14 ring carbon atoms, and further preferably 6 to 10 ring carbon atoms. A phenyl group and a naphthyl group are preferable.

Examples of the substituted or unsubstituted heterocyclic group include a pyrrolyl group, a pyrazinyl group, a pyridinyl group, an indolyl group, an isoindoly group, a furyl group, a benzofuranyl group, an isobenzofuranyl group, a dibenzofuranyl group, a dibenzothiophenyl group, a quinolyl group, an isoquinolyl group, a quinoxanyl group, a carbazolyl group, a phenanthrydinyl group, an acrydinyl group, a phenanthronyl group, a phenazinyl group, a phenothiazinyl group, a phenoxazinyl group, an oxazolyl group, an oxadiazolyl group, a furazanyl group, a thienyl group, a 2-methylpyrrolyl group, a 3-methylpyrrolyl group, a 2-t-butylpyrrolyl group and a 3-(2-phenylpropyl)pyrrolyl group.

The substituted or unsubstituted heterocyclic group preferably has 5 to 20 ring atoms, further preferably 5 to 14 ring atoms.
The heterocyclic group is preferably a dibenzofuranyl group, a dibenzothiophenyl group and a carbazolyl group.

The arylsily group is represented by $-SiZ_3$, and as examples of Z, the same examples as those for the aryl group mentioned above can be given.

The alkoxy group is represented by -OY, and as examples of Y, the same examples of those for the alkyl group and or the aryl group mentioned above can be given.

Examples of the cycloalkyl group include a cycloproply group, a cyclobutyl group, a cyclopentyl group, a cyclohexyl group, a 4-methylcyclohexyl group, a 1-adamantyl group, a 2-adamantyl group, a 1-norbonyl group and a 2-norbonyl group. The cycloalkyl group has preferably 3 to 10 ring carbon atoms, more preferably 3 to 8 ring carbon atoms, and further preferably 3 to 6 ring carbon atoms.
Specific examples of the compound having at least one electron-attracting group in the molecular structure thereof are given below.

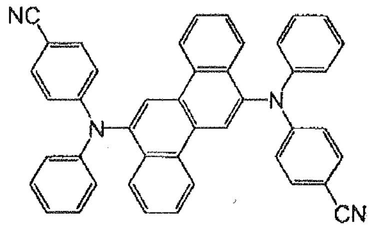 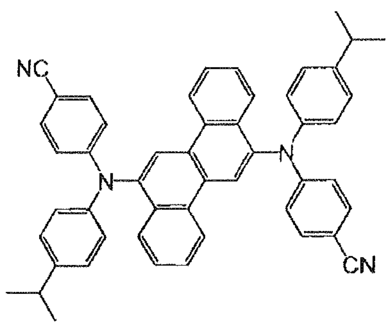

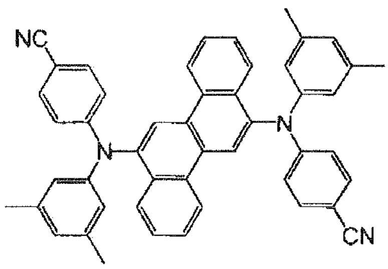

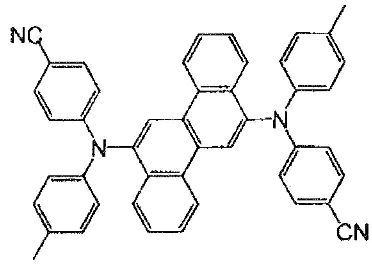

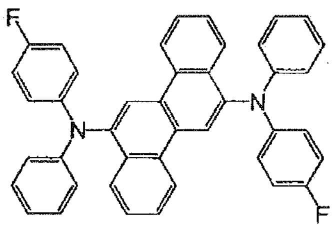

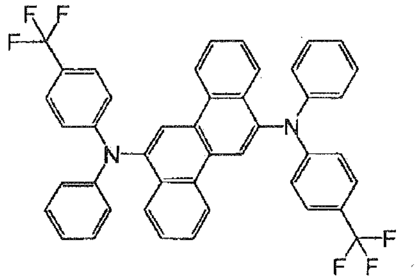

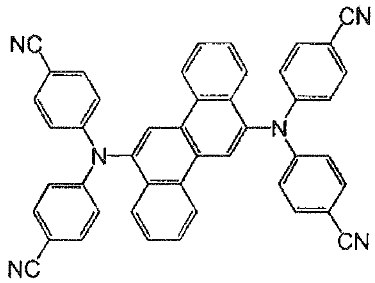

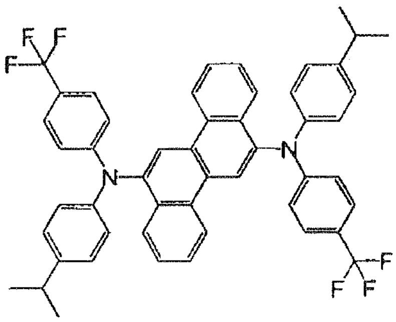

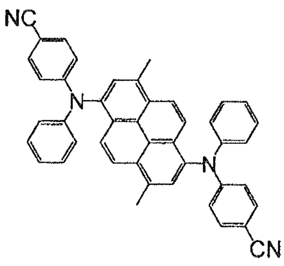

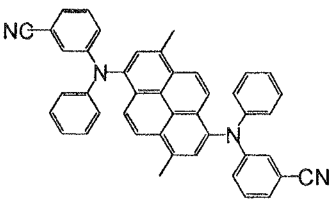

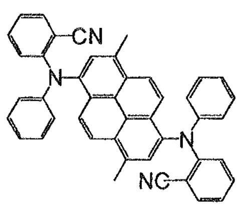

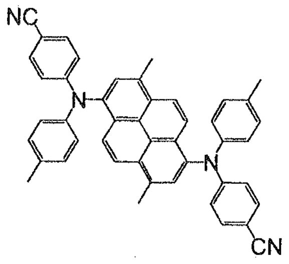
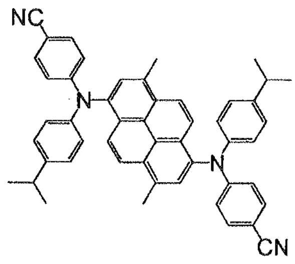
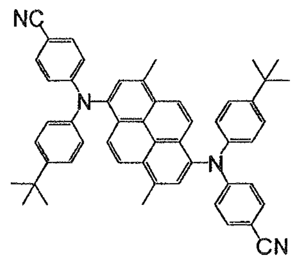

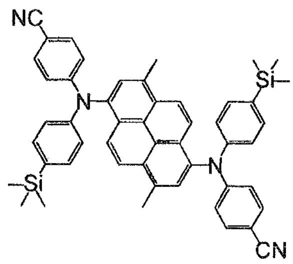
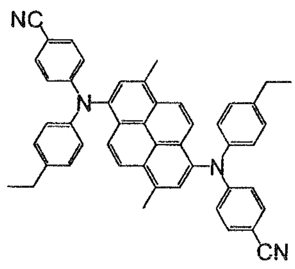
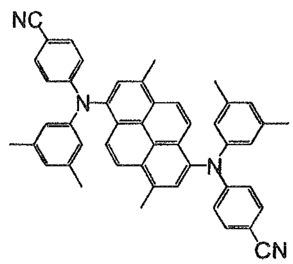

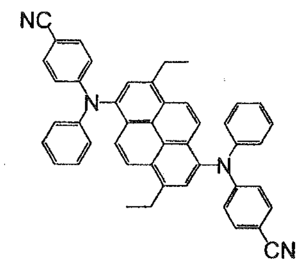
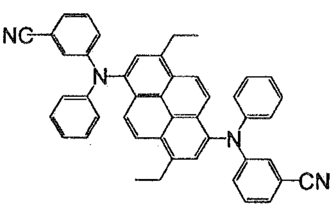
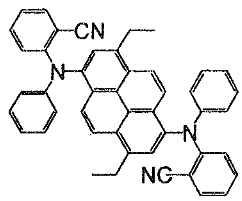

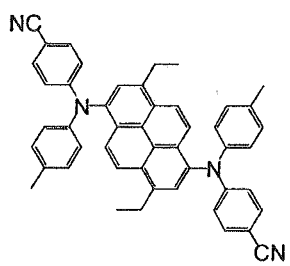
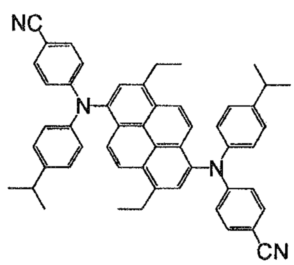
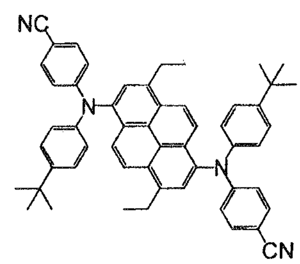

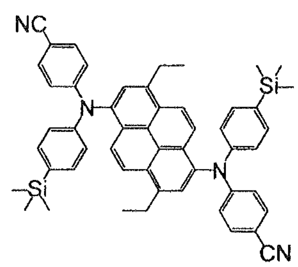
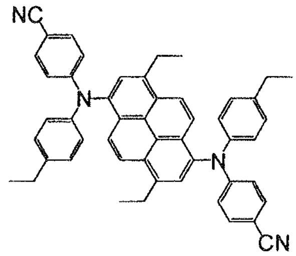
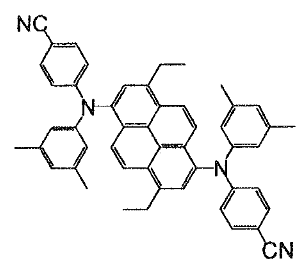

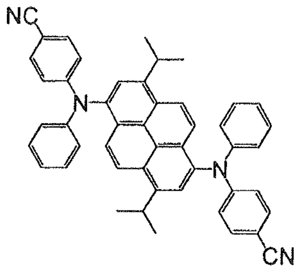
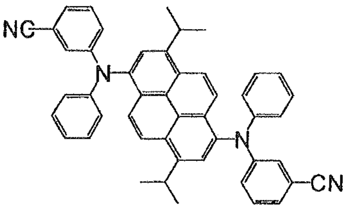
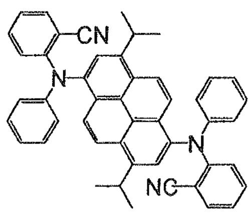

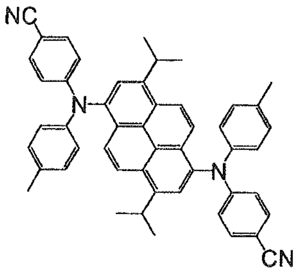
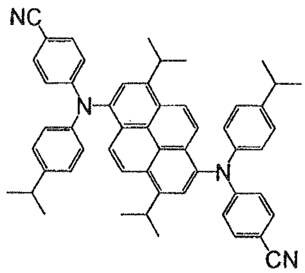
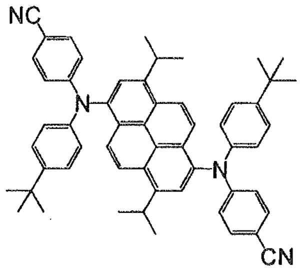

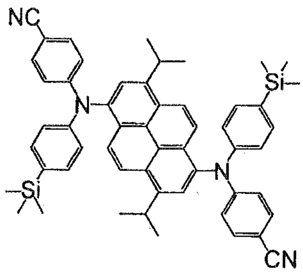
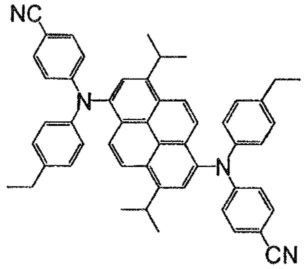
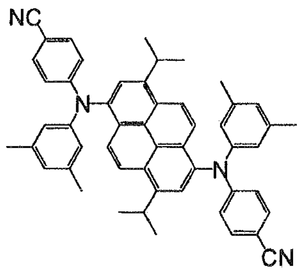

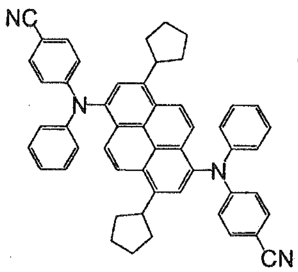
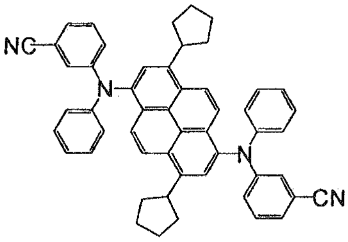
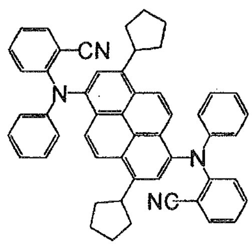

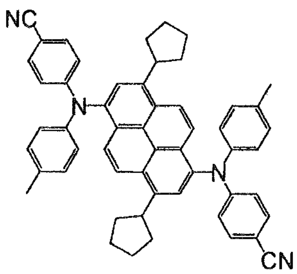
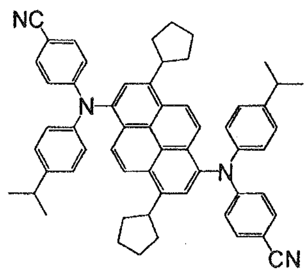
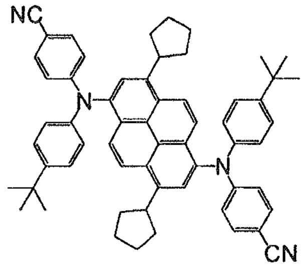

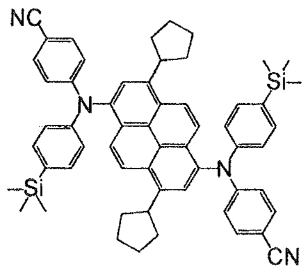
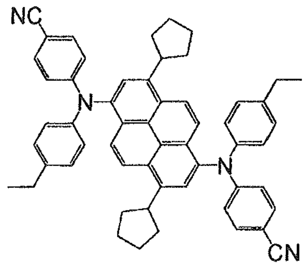
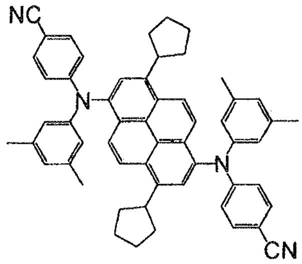

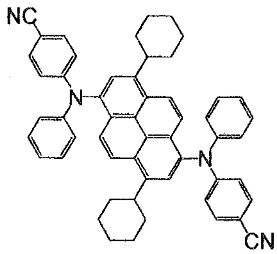
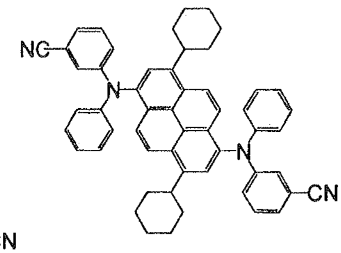
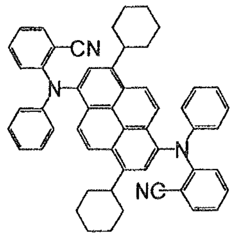

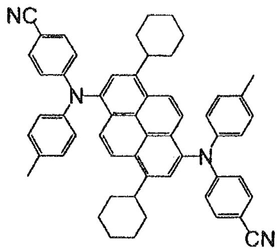
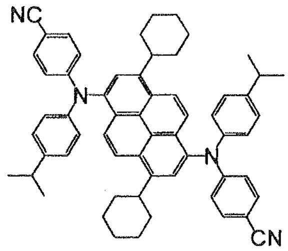
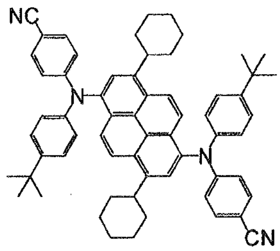

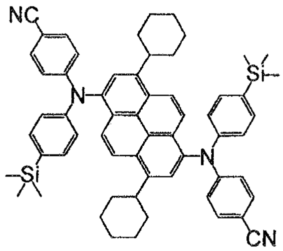
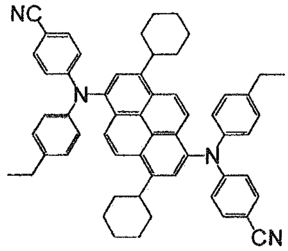
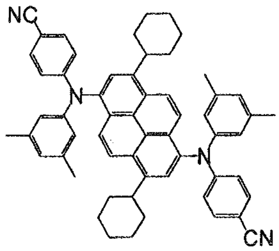

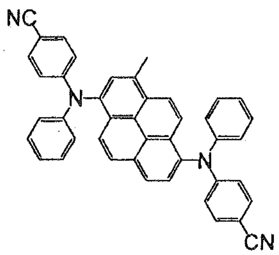
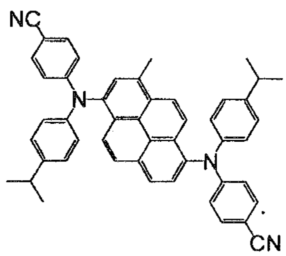
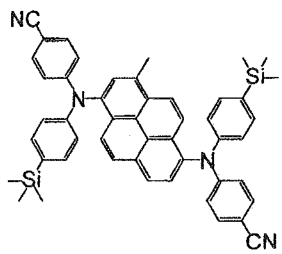

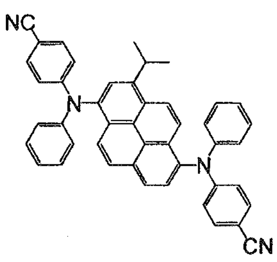
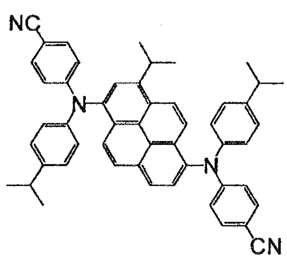
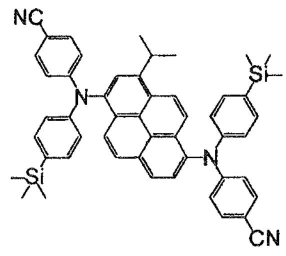

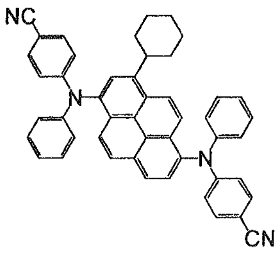
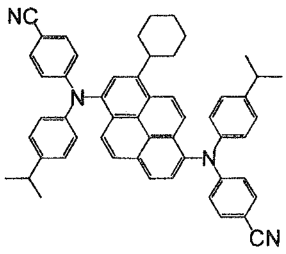
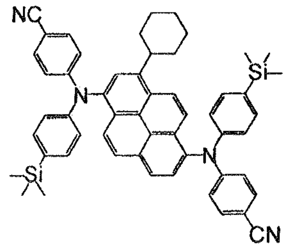

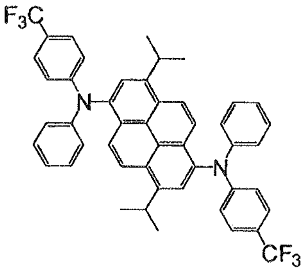
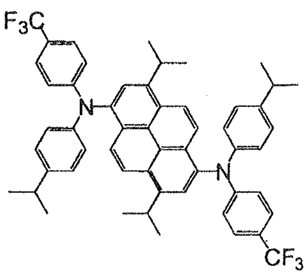
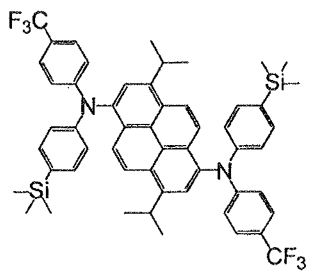

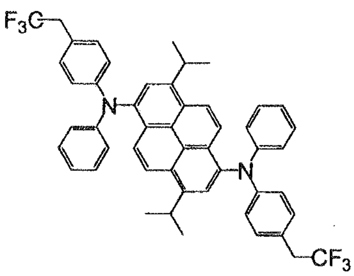
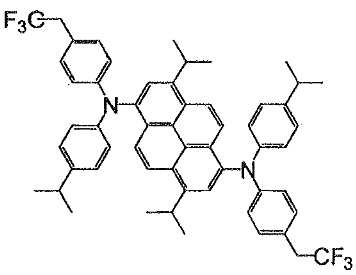
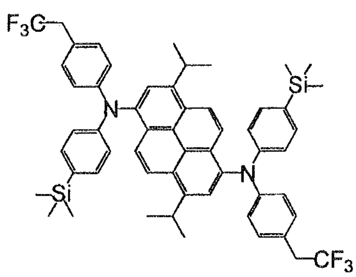

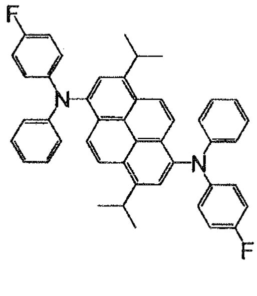
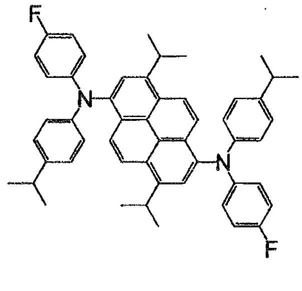
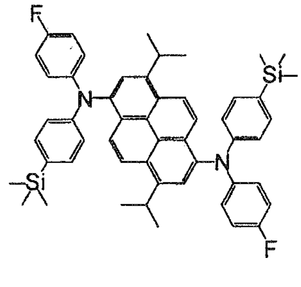

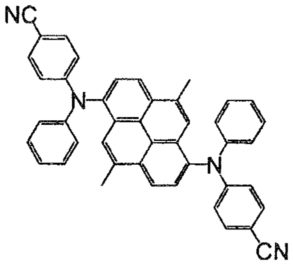
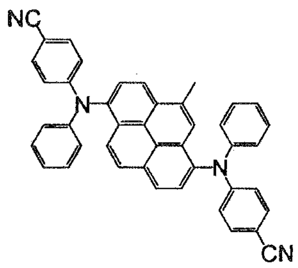
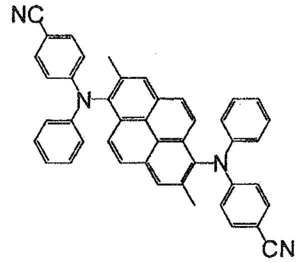
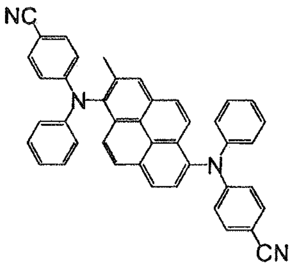
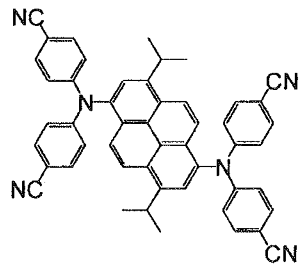
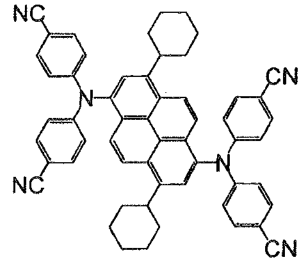
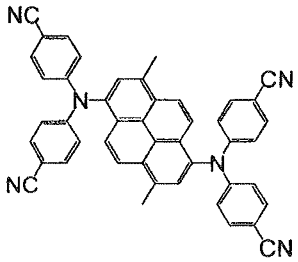
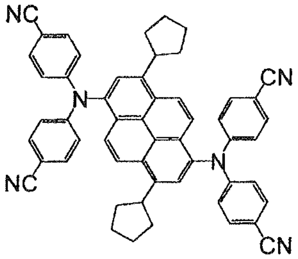
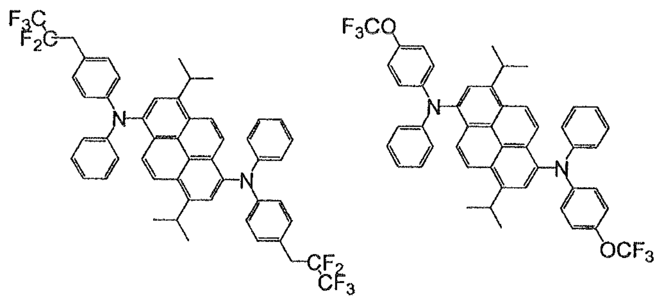
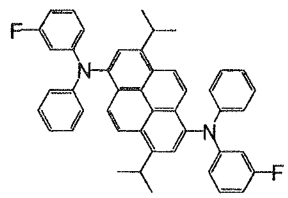
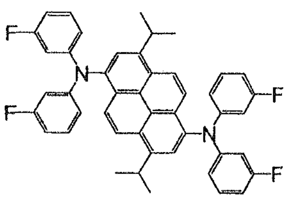
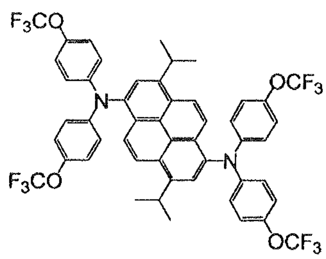
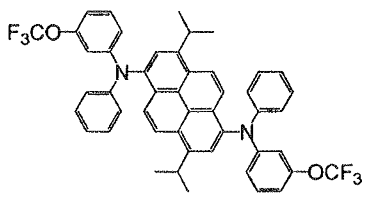

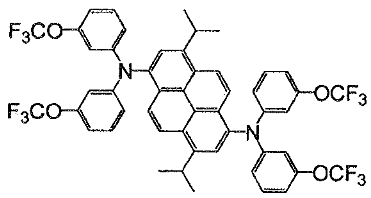

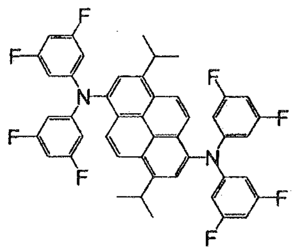

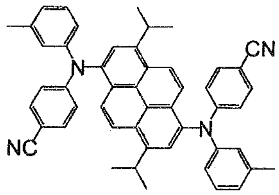

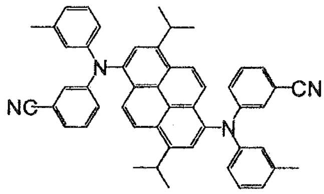

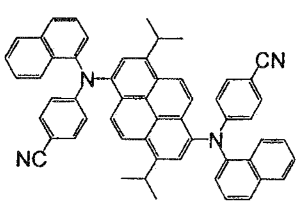

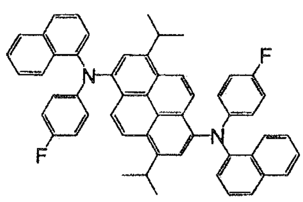

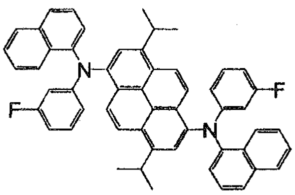

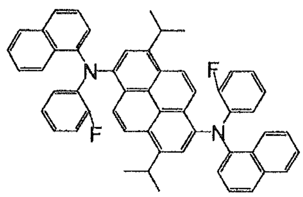

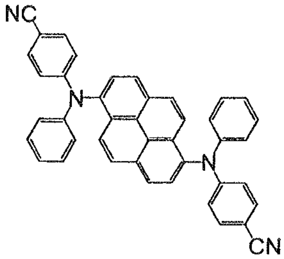

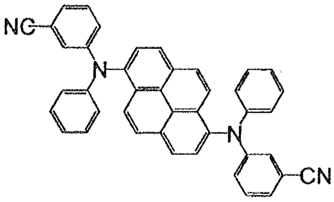

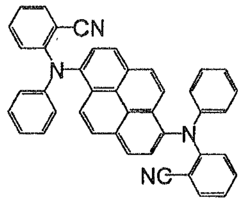

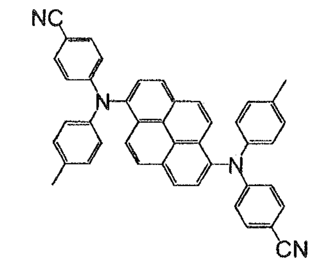
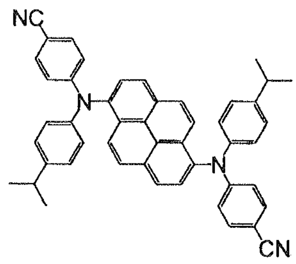
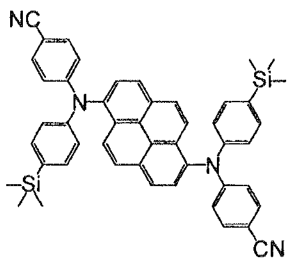

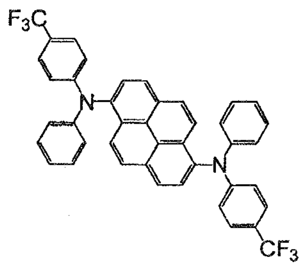
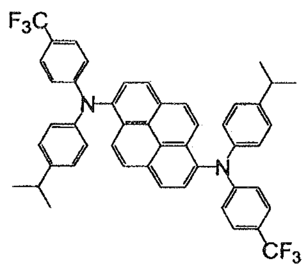
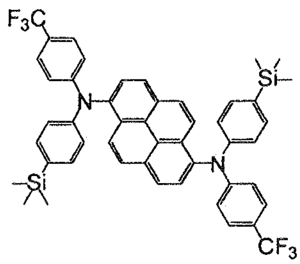

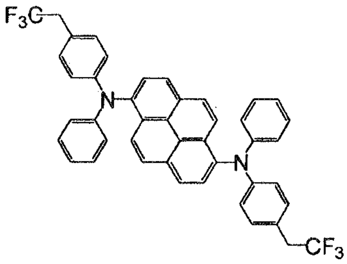
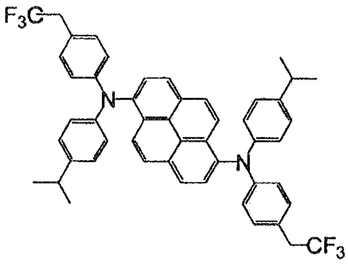
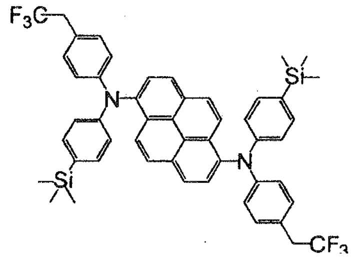

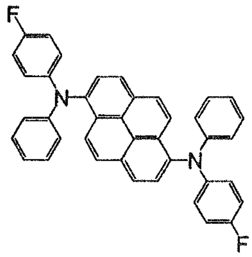
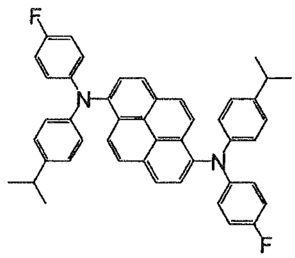
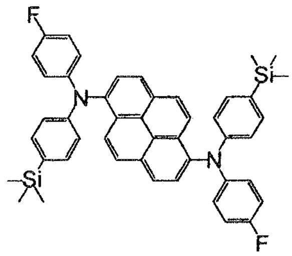

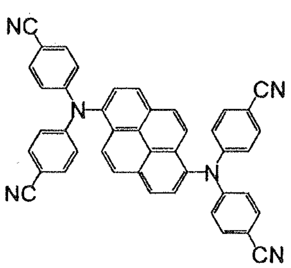
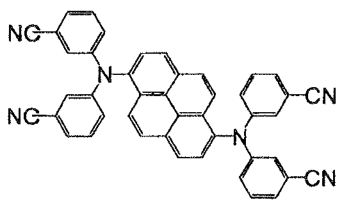
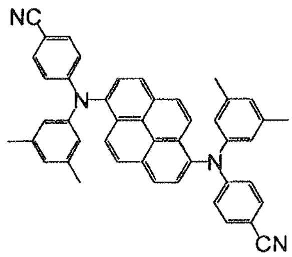

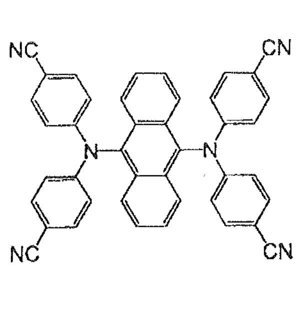
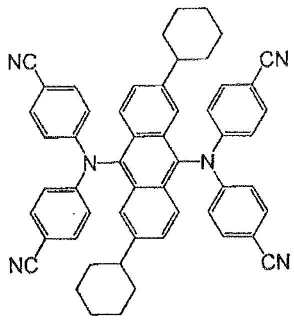
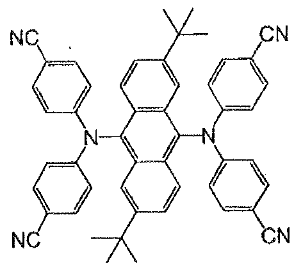

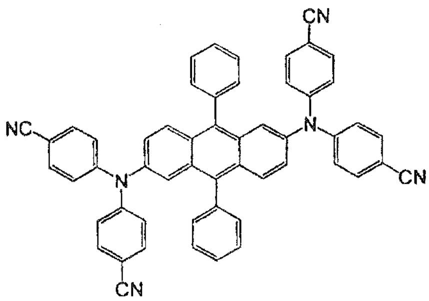
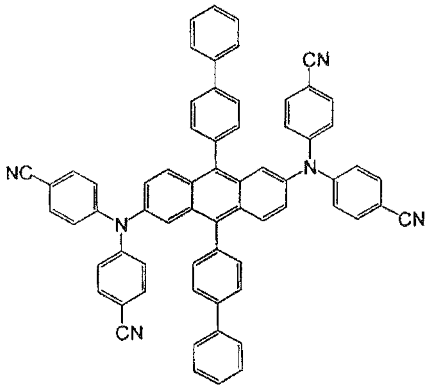

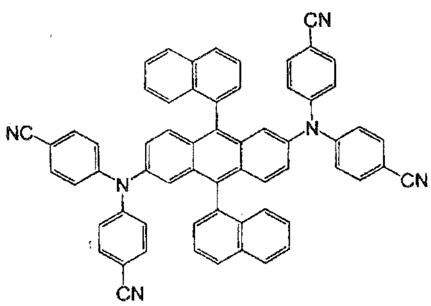
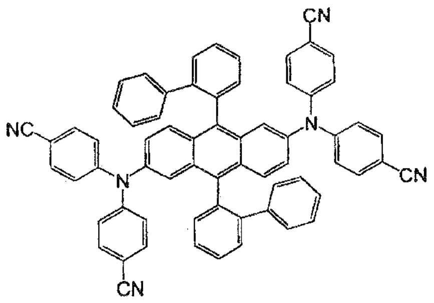

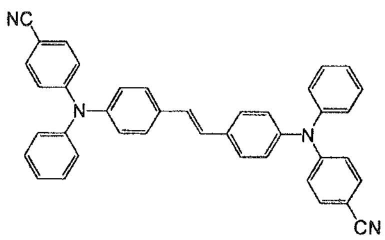
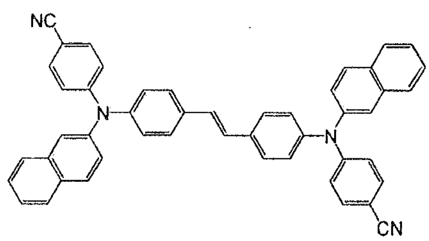

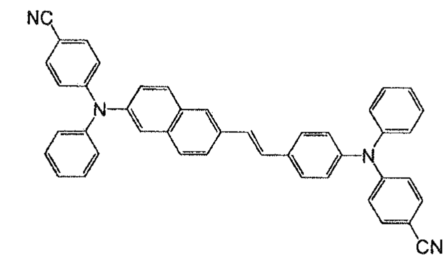
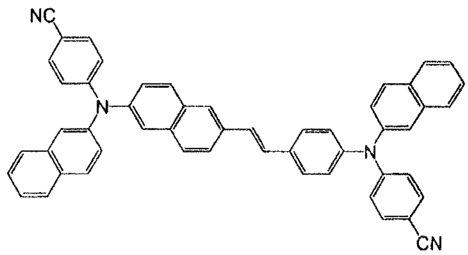
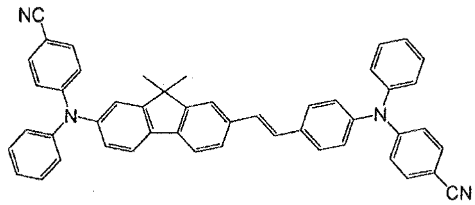
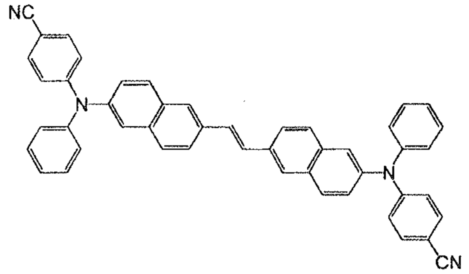

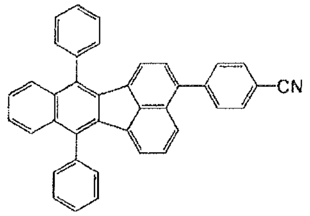
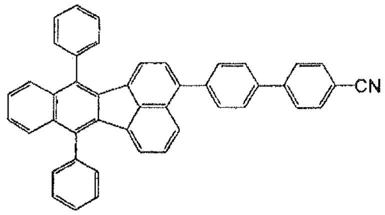

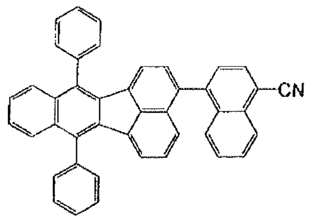
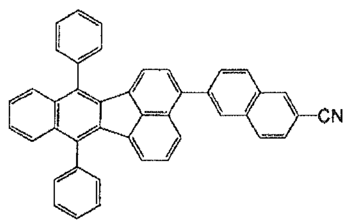

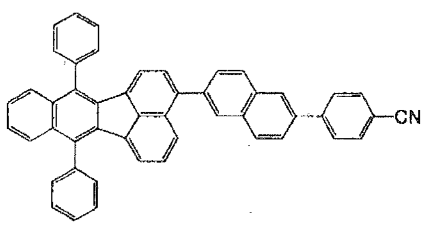
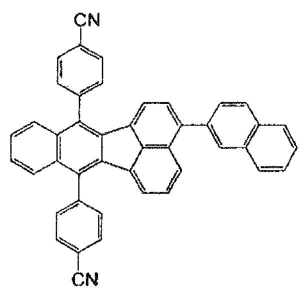

In the organic luminescence medium of the invention, it is preferred that a compound having at least one electron-attracting group in the molecular structure thereof be contained as a doping material (dopant). In this case, the amount of the above-mentioned compound is preferably 0.1 to 20 mass%, more preferably 1 to 10 mass%.

The anthracene derivative of the invention and the compound having an electron-attracting group can be used, in addition to the emitting layer, in the hole-injecting layer, the hole-transporting layer, the electron-injecting layer and the electron-transporting layer.

In the invention, as the organic EL device in which the organic compound layer (organic thin film layer) is

composed of plural layers, one in which layers are sequentially stacked (anode/hole-injecting layer/emitting layer/cathode), (anode/emitting layer/electron-injecting layer/cathode), (anode/hole-injecting layer/emitting layer/electron-injecting layer/cathode), (anode/hole-injecting layer/hole-transporting layer/emitting layer/electron-injecting layer/cathode) or the like can be given.

By allowing the organic thin film layer to be composed of plural layers, the organic EL device can be prevented from lowering of luminance or lifetime due to quenching. If necessary, an emitting material, a doping material, a hole-injecting material or an electron-injecting material can be used in combination. Further, due to the use of a doping material, luminance or luminous efficiency may be improved. The hole-injecting layer, the emitting layer and the electron-injecting layer may respectively be formed of two or more layers. In such case, in the hole-injecting layer, a layer which injects holes from an electrode is referred to as a hole-injecting layer, and a layer which receives holes from the hole-injecting layer and transports the holes to the emitting layer is referred to as a hole-transporting layer. Similarly, in the electron-injecting layer, a layer which injects electrons from an electrode is referred to as an electron-injecting layer and a layer which receives electrons from an electron-injecting layer and transports the electrons to the emitting layer is referred to as an electron-transporting layer. Each of these layers is selected and used according to each of the factors of a material, i.e. the energy level, heat resistance, adhesiveness to the organic layer or the metal electrode or the like.

Examples of a material other than the above-mentioned anthracene derivative of the invention which can be used in the emitting layer together with the compound having an electron-attracting group of the invention include, though not limited thereto, fused polycyclic aromatic compounds such as naphthalene, phenanthrene, rubrene, anthracene, tetracene, pyrene, perylene, chrysene, decacyclene, coronene, tetraphenylcyclopentadiene, pentaphenylcyclopentadiene, fluorene and spirofluorene and derivatives thereof, organic metal complexes such as tris(8-quinolinolate)aluminum, triarylamine derivatives, styrylamine derivatives, stilbene derivatives, coumarin derivatives, pyrane derivatives, oxazone derivatives, benzothiazole derivatives, benzoxazole derivatives, benzimidazole derivatives, pyrazine derivatives, cinnamate derivatives, diketo-pyrrolo-pyrrole derivatives, acridone derivatives and quinacridone derivatives.

As the hole-injecting material, a compound which can transport holes, exhibits hole-injecting effects from the anode and excellent hole-injection effect for the emitting layer or the emitting material, and has an excellent capability of forming a thin film is preferable. Specific examples thereof include, though not limited thereto, phthalocyanine derivatives, naphthalocyanine derivatives, porphyline derivatives, benzidine-type triphenylamine, diamine-type triphenylamine, hexacyanohexaazatriphenylene, derivatives thereof, and polymer materials such as polyvinylcarbazole, polysilane and conductive polymers.

Of the hole-injecting materials usable in the organic EL device of the invention, further effective hole-injecting materials are phthalocyanine derivatives.

Examples of the phthalocyanine (Pc) derivative include, though not limited thereto, phthalocyanine derivatives such as $H_2Pc$, CuPc, CoPc, NiPc, ZnPc, PdPc, FePc, MnPc, ClAlPc, ClGaPc, ClInPc, ClSnPc, $Cl_2SiPc$, (HO)AlPc, (HO)GaPc, VOPc, TiOPc, MoOPc and GaPc-O-GaPc, and naphthalocyanine derivatives.

In addition, it is also possible to sensitize carriers by adding to the hole-injecting material an electron-accepting substance such as a TCNQ derivative.

Preferable hole-transporting materials usable in the organic EL device of the invention are aromatic tertiary amine derivatives.

Examples of the aromatic tertiary amine derivative include, though not limited thereto, N,N'-diphenyl-N,N'-dinaphthyl-1,1'-biphenyl-4,4'-diamine, N,N,N',N'-tetrabiphenyl-1,1'-biphenyl-4,4'-diamine or an oligomer or a polymer having these aromatic tertiary amine skeletons.

As the electron-injecting material, a compound which can transport electrons, exhibits electron-injecting effects from the cathode and excellent electron-injection effect for the emitting layer or the emitting material, and has an excellent capability of forming a thin film is preferable.

In the organic EL device of the invention, further effective electron-injecting materials are a metal complex compound and a nitrogen-containing heterocyclic derivative.

Examples of the metal complex compound include, though not limited thereto, 8-hydroxyquinolinate lithium, bis(8-hydroxyquinolinate)zinc, tris(8-hydroxyquinolinate)aluminum, tris(8-hydroxyquinolinate)gallium, bis(10-hydroxybenzo[h]quinolinate)beryllium and bis(10-hydroxybenzo[h]quinolinate)zino.

As examples of the nitrogen-containing heterocyclic derivative, oxazole, thiazole, oxadiazole, thiadiazole, triazole, pyridine, pyrimidine, triazine, phenanthroline, benzimidazole, imidazopyridine or the like are preferable, for example. Of these, a benzimidazole derivative, a phenanthroline derivative and an imidazopyridine derivative are preferable.

As a preferred embodiment, a dopant is further contained in these electron-injecting materials, and in order to facilitate receiving electrons from the cathode, it is further preferable to dope the vicinity of the cathode interface of the second organic layer with a dopant, the representative example of which is an alkali metal.

As the dopant, a donating metal, a donating metal compound and a donating metal complex can be given. These reducing dopants may be used singly or in combination of two or more.

In the organic EL device of the invention, the emitting layer may contain, in addition to at least one selected from the pyrene derivatives represented by the formula (1), at least one of an emitting material, a doping material, a hole-injecting material, a hole-transporting material and an electron-injecting material in the same layer. Moreover, for improving stability of the organic EL device obtained by the invention to temperature, humidity, atmosphere, etc. it is also possible to prepare a protective layer on the surface of the device, and it is also possible to protect the entire device by applying silicone oil, resin, etc.

As the conductive material used in the anode of the organic EL device of the invention, a conductive material having a work function of more than 4 eV is suitable. Carbon, aluminum, vanadium, iron, cobalt, nickel, tungsten, silver, gold, platinum, palladium or the like, alloys thereof, oxidized metals which are used in an ITO substrate and a NESA substrate such as tin oxide and indium oxide and organic conductive resins such as polythiophene and polypyrrole are used. As the conductive material used in the cathode, a conductive material having a work function of smaller than 4 eV is suitable. Magnesium, calcium, tin, lead, titanium, yttrium, lithium, ruthenium, manganese, aluminum, and lithium fluoride or the like, and alloys thereof are used, but not limited thereto. Representative examples of the alloys include, though not limited thereto, magnesium/silver alloys, magnesium/indium alloys and lithium/aluminum alloys. The amount ratio of the alloy is controlled by the temperature of the deposition source, atmosphere, vacuum degree or the like, and an appropriate ratio is selected. If necessary, the anode and the cathode each may be composed of two or more layers.

In the organic EL device of the invention, in order to allow it to emit light efficiently, it is preferred that at least one of the surfaces be fully transparent in the emission wavelength region of the device. In addition, it is preferred that the substrate also be transparent. The transparent electrode is set such that predetermined transparency can be ensured by a method such as deposition or sputtering by using the above-mentioned conductive materials. It is preferred that the electrode on the emitting surface have a light transmittance of 10% or more. Although no specific restrictions are imposed on the substrate as long as it has mechanical and thermal strength and transparency, a glass substrate and a transparent resin film can be given.

Each layer of the organic EL device of the invention can be formed by a dry film-forming method such as vacuum vapor deposition, sputtering, plasma plating, ion plating or the like or a wet film-forming method such as spin coating, dipping, flow coating or the like. Although the film thickness is not particularly limited, it is required to adjust the film thickness to an appropriate value. If the film thickness is too large, a large voltage is required to be applied in order to obtain a certain optical output, which results in a poor efficiency. If the film thickness is too small, pinholes or the like are generated, and a sufficient luminance cannot be obtained even if an electrical field is applied. The suitable film thickness is normally 5 nm to 10 $\mu$m, with a range of 10 nm to 0.2 $\mu$m being further preferable.

In the case of the wet film-forming method, a thin film is formed by dissolving or dispersing materials forming each layer in an appropriate solvent such as ethanol, chloroform, tetrahydrofuran and dioxane. Any of the above-mentioned solvents can be used.

As the solution suited to such a wet film-forming method, a solution containing the compound having an electron-attracting group of the invention as an organic EL material and a solvent can be used.

It is preferred that the organic EL material contain a host material and a dopant material, that the dopant material be the compound having an electron-attracting group of the invention, and that the host material be the anthracene derivative of the invention.

In each organic thin film layer, an appropriate resin or additive may be used in order to improve film-forming properties, to prevent generation of pinholes in the film, or for other purposes.

The organic EL device of the invention can be suitably used as a planar emitting body such as a flat panel display of a wall-hanging television, backlight of a copier, a printer or a liquid crystal display, light sources for instruments, a display panel, a navigation light, or the like. The compound of the invention can be used not only in an organic EL device but also in the field of an electrophotographic photoreceptor, a photoelectric converting element, a solar cell and an image sensor.

## EXAMPLES

### Example 1

A glass substrate of 25 mm by 75 mm by 1.1 mm thick with an ITO transparent electrode (anode) (GEOMATEC CO., LTD.) was subjected to ultrasonic cleaning in isopropyl alcohol for 5 minutes, and cleaning with UV/ozone for 30 minutes. The cleaned glass substrate with transparent electrode lines was mounted on a substrate holder in a vacuum deposition apparatus. First, compound A-1 was deposited on the surface on which the transparent electrode lines were formed to form a 50 nm-thick film so as to cover the transparent electrode. Subsequently, compound A-2 was deposited on the A-1 film to form a 45 nm-thick film.

Compound EM-1 and compound DM-1 of the invention were deposited on the A-2 film into a thickness of 20 nm such that the film thickness ratio of EM-1 and DM-1 became 20:1 to form a blue emitting layer.

On this film, the following ET-1 was deposited into a thickness of 30 nm as an electron-transporting layer. Then, LiF was deposited into a thickness of 1 nm. Metallic Al was deposited on the LiF film into a thickness of 150 nm to form a metallic cathode, whereby an organic EL device was fabricated.

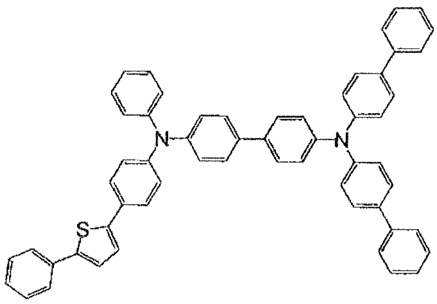

A－1

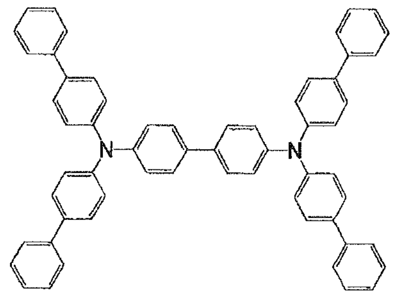

A－2

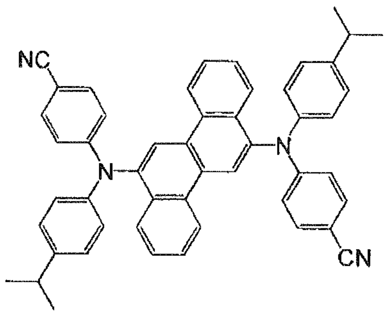

DM－1

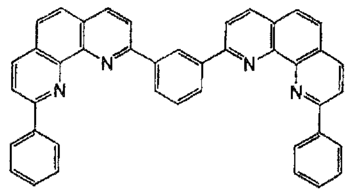

ET－1

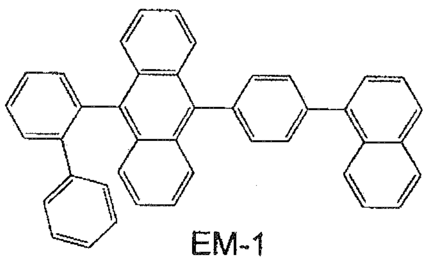

EM-1

Examples 2 to 48 and Comparative Examples 1 to 7

Organic EL devices were produced in the same manner as in Example 1, except that the host material and doping material shown in Tables 1 and 2 were used.
The doping materials used in each example are shown below.

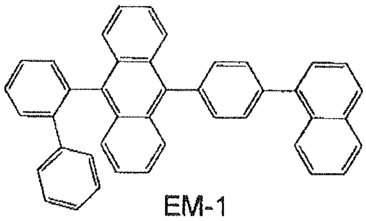
EM-1

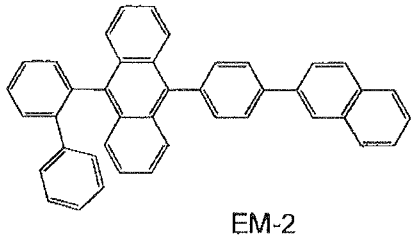
EM-2

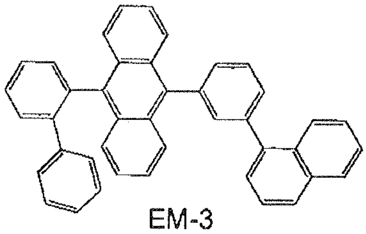
EM-3

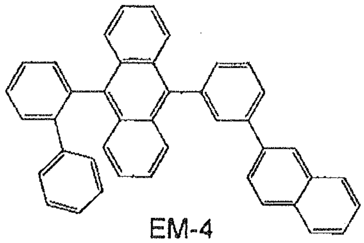
EM-4

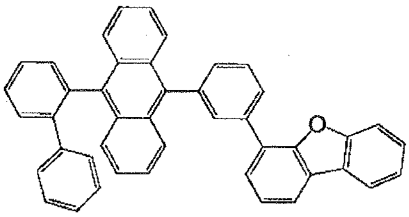
EM-5

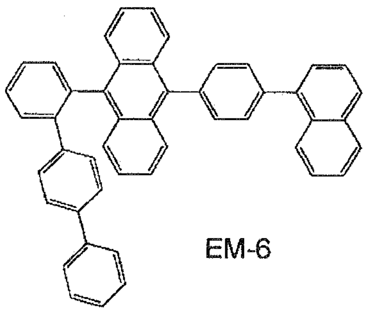
EM-6

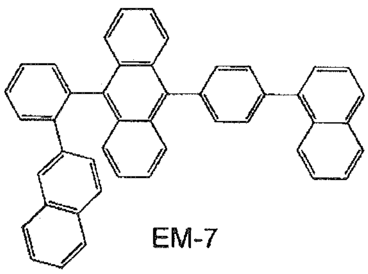
EM-7

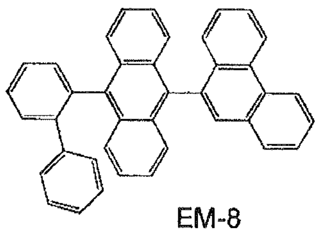
EM-8

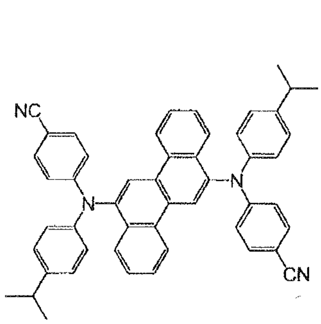
DM－1

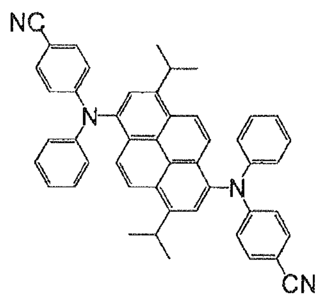
DM－2

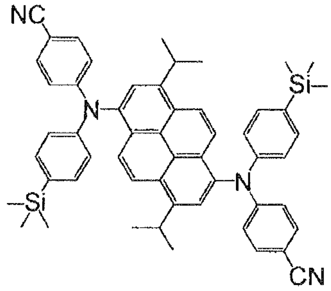

DM－3

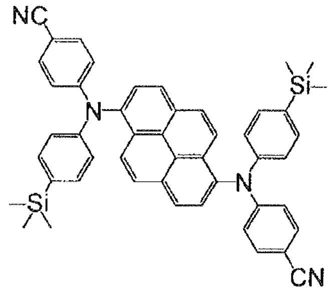

DM－4

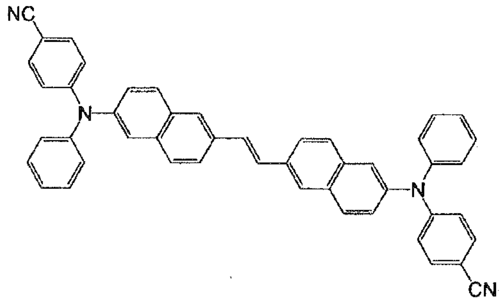

DM－5

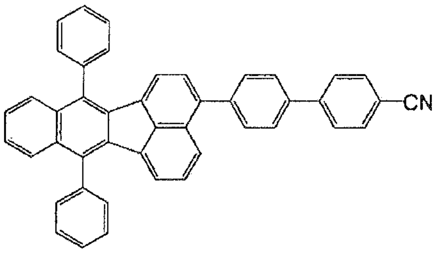

DM－6

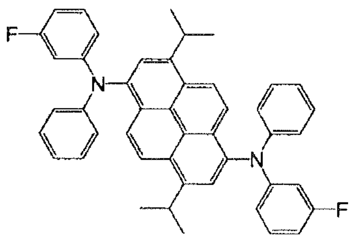

DM－7

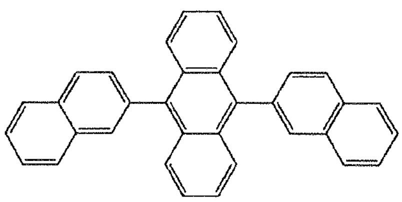

Compound A

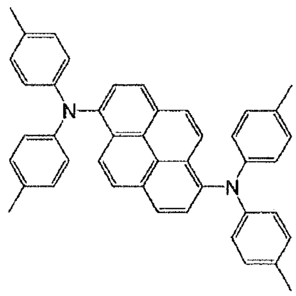

Compound B

Current having a current density of 10 mA/cm$^2$was applied to the resulting organic EL devices. EL spectra thereof were measured with a spectroradiometer (CS1000, produced by MINOLTA), and external quantum efficiency was calculated by the following formula (1).
The lifetime of the organic EL device was evaluated by measuring the half life at 500 cd/m$^2$ of initial luminance. The results are shown in Tables 1 and 2.

$$E.Q.E. = \frac{N_P}{N_E} \times 100$$

$$= \frac{\dfrac{(\pi/10^9)\int \phi(\lambda)\cdot d\lambda}{hc}}{\dfrac{J/10}{e}} \times 100$$

$$\doteqdot \frac{\dfrac{(\pi/10^9)\,\Sigma(\phi(\lambda)\cdot(\lambda))}{hc}}{\dfrac{J/10}{e}} \times 100\ (\%)$$

Np: Number of photons
$N_E$: Number of electrons
π: Circular constant = 3.1416
λ: Wavelength (nm)
φ: Luminescence intensity ($W/sr \cdot m^2 \cdot nm$)
h: Planck constant = $6.63 \times 10^{-34}$ (J·s)
c: Light velocity = $3 \times 10^8$ (m/s)
J: Current density ($mA/cm^2$)
e: Charge = $1.6 \times 10^{-19}$ (C)

Table 1

| | Host | Dopant | CIEx | CIEy | EQE (%) | Lifetime (h) |
|---|---|---|---|---|---|---|
| Example 1 | EM-1 | DM-1 | 0.144 | 0.067 | 4.5 | 2000 |
| Example 2 | EM-2 | DM-1 | 0.144 | 0.070 | 4.7 | 2100 |
| Example 3 | EM-3 | DM-1 | 0.144 | 0.068 | 4.6 | 2100 |
| Example 4 | EM-4 | DM-1 | 0.144 | 0.068 | 4.6 | 2100 |
| Example 5 | EM-5 | DM-1 | 0.144 | 0.068 | 4.8 | 1800 |
| Example 6 | EM-6 | DM-1 | 0.144 | 0.067 | 4.6 | 2300 |
| Example 7 | EM-7 | DM-1 | 0.144 | 0.068 | 4.5 | 2000 |
| Example 8 | EM-8 | DM-1 | 0.144 | 0.069 | 4.7 | 1800 |
| Example 9 | EM-1 | DM-2 | 0.137 | 0.090 | 4.6 | 3000 |
| Example 10 | EM-2 | DM-2 | 0.137 | 0.093 | 4.8 | 3100 |
| Example 11 | EM-3 | DM-2 | 0.137 | 0.091 | 4.7 | 3100 |
| Example 12 | EM-4 | DM-2 | 0.137 | 0.091 | 4.7 | 3100 |
| Example 13 | EM-5 | DM-2 | 0.137 | 0.091 | 4.9 | 2800 |
| Example 14 | EM-6 | DM-2 | 0.137 | 0.090 | 4.7 | 3300 |
| Example 15 | EM-7 | DM-2 | 0.137 | 0.091 | 4.6 | 3000 |

(continued)

| | Host | Dopant | CIEx | CIEy | EQE (%) | Lifetime (h) |
|---|---|---|---|---|---|---|
| Example 16 | EM-8 | DM-2 | 0.137 | 0.092 | 4.8 | 2800 |
| Example 17 | EM-1 | DM-3 | 0.137 | 0.090 | 5.1 | 2900 |
| Example 18 | EM-2 | DM-3 | 0.137 | 0.093 | 5.3 | 3000 |
| Example 19 | EM-3 | DM-3 | 0.137 | 0.091 | 5.2 | 3000 |
| Example 20 | EM-4 | DM-3 | 0.137 | 0.091 | 5.2 | 3000 |
| Example 21 | EM-5 | DM-3 | 0.137 | 0.091 | 5.4 | 2700 |
| Example 22 | EM-6 | DM-3 | 0.137 | 0.090 | 5.2 | 3200 |
| Example 23 | EM-7 | DM-3 | 0.137 | 0.091 | 5.1 | 2900 |
| Example 24 | EM-8 | DM-3 | 0.137 | 0.092 | 5.3 | 2700 |
| Example 25 | EM-1 | DM-4 | 0.136 | 0.086 | 4.6 | 2700 |
| Example 26 | EM-2 | DM-4 | 0.136 | 0.089 | 4.8 | 2800 |
| Example 27 | EM-3 | DM-4 | 0.136 | 0.087 | 4.7 | 2800 |
| Example 28 | EM-4 | DM-4 | 0.136 | 0.087 | 4.7 | 2800 |
| Example 29 | EM-5 | DM-4 | 0.136 | 0.087 | 4.9 | 2500 |
| Example 30 | EM-6 | DM-4 | 0.136 | 0.086 | 4.7 | 3000 |

Table 2

| | Host | Dopant | CIEx | CIEy | EQE (%) | Lifetime (h) |
|---|---|---|---|---|---|---|
| Example 31 | EM-7 | DM-4 | 0.136 | 0.087 | 4.6 | 2700 |
| Example 32 | EM-8 | DM-4 | 0.136 | 0.088 | 4.8 | 2500 |
| Example 33 | EM-1 | DM-5 | 0.147 | 0.070 | 4.6 | 2900 |
| Example 34 | EM-2 | DM-5 | 0.147 | 0.073 | 4.8 | 3000 |
| Example 35 | EM-3 | DM-5 | 0.147 | 0.071 | 4.7 | 3000 |
| Example 36 | EM-4 | DM-5 | 0.147 | 0.071 | 4.7 | 3000 |
| Example 37 | EM-5 | DM-5 | 0.147 | 0.071 | 4.9 | 2700 |
| Example 38 | EM-6 | DM-5 | 0.147 | 0.070 | 4.7 | 3200 |
| Example 39 | EM-7 | DM-5 | 0.147 | 0.071 | 4.6 | 2900 |
| Example 40 | EM-8 | DM-5 | 0.147 | 0.072 | 4.8 | 2700 |
| Example 41 | EM-1 | DM-6 | 0.142 | 0.106 | 7.2 | 4900 |
| Example 42 | EM-2 | DM-6 | 0.142 | 0.109 | 7.4 | 5000 |
| Example 43 | EM-3 | DM-6 | 0.142 | 0.107 | 7.3 | 5000 |
| Example 44 | EM-4 | DM-6 | 0.142 | 0.107 | 7.3 | 5000 |
| Example 45 | EM-5 | DM-6 | 0.142 | 0.107 | 7.5 | 4700 |
| Example 46 | EM-6 | DM-6 | 0.142 | 0.106 | 7.3 | 5200 |
| Example 47 | EM-7 | DM-6 | 0.142 | 0.107 | 7.2 | 4900 |
| Example 48 | EM-8 | DM-6 | 0.142 | 0.108 | 7.4 | 4700 |
| Example 49 | EM-1 | DM-7 | 0.141 | 0.091 | 5.8 | 2700 |

(continued)

| | Host | Dopant | CIEx | CIEy | EQE (%) | Lifetime (h) |
|---|---|---|---|---|---|---|
| Example 50 | EM-2 | DM-7 | 0.140 | 0.090 | 5.8 | 2500 |
| Example 51 | EM-3 | DM-7 | 0.142 | 0.092 | 6.0 | 2800 |
| Example 52 | EM-4 | DM-7 | 0.141 | 0.091 | 5.9 | 2700 |
| Example 53 | EM-5 | DM-7 | 0.141 | 0.090 | 5.9 | 2600 |
| Example 54 | EM-6 | DM-7 | 0.141 | 0.092 | 6,1 | 2800 |
| Example 55 | EM-7 | DM-7 | 0.142 | 0.092 | 6.2 | 2700 |
| Example 56 | EM-8 | DM-7 | 0.142 | 0.092 | 6.1 | 2700 |
| Com. Ex. 1 | Compound A | DM-1 | 0.144 | 0.075 | 4.2 | 1000 |
| Com. Ex. 2 | Compound A | DM-2 | 0.137 | 0.095 | 4.4 | 1200 |
| Com. Ex. 3 | Compound A | DM-3 | 0.137 | 0.095 | 4.7 | 1300 |
| Com. Ex. 4 | Compound A | DM-4 | 0.136 | 0.090 | 4.7 | 1200 |
| Com. Ex. 5 | Compound A | DM-5 | 0.147 | 0.076 | 4.5 | 1100 |
| Com. Ex. 6 | Compound A | DM-6 | 0.142 | 0.112 | 7.3 | 3500 |
| Com. Ex. 7 | Compound A | DM-7 | 0.140 | 0.104 | 4.9 | 1200 |
| Com. Ex. 8 | EM-1 | Compound B | 0.114 | 0.222 | 4.8 | 1200 |

Since the 9th position or the 10th position of the anthracene derivative has a high electron density, a phenyl group substituted with an aryl or heteroaryl group at the ortho position which substitutes these positions has improved effects of preventing aggregation. Therefore, as compared with other anthracene derivatives, an anthracene derivative having such a substituent has characteristics that it allows an organic EL device to emit blue color with a high purity. However, as compared with other anthracene derivatives, this type of anthracene derivative tends to allow an organic EL device to emit light in the interface nearer to the hole-transporting material. Therefore, excessive electrons are likely to enter the hole-transporting material, and as a result, the hole-transporting material is deteriorated to shorten the lifetime of an organic EL device. On the other hand, the dopant, which is the characteristic feature of the invention, has an electron-attracting group, and hence has effects of trapping excessive electrons. Therefore, it is assumed that, by using the anthracene derivative and the dopant of the invention in combination, pure blue color emission and prolongation of life time due to the suppression of entering of electrons to the hole-transporting material can be realized.
Further, when Comparative Examples 1 to 7 are compared with Comparative Example 8, it can be understood that color purity is enhanced due to the presence of the compound containing an electron-attracting group. It can also be understood that emission with a further shorter wavelength can be attained by combining the anthracene derivative (1) of the invention which is bulky and exhibits aggregation prevention effects due to the presence of $Ar_2$.
The combination of the invention is a combination which enables pure blue emission to be kept and can realize prolongation of life time.
As a result, a display device having a long lifetime and a high color reproducibility can be realized.

INDUSTRIAL APPLICABILITY

The organic EL device of the invention can be used as a planar emitting body such as a flat panel display of a wall-hanging television, backlight of a copier, a printer, or a liquid crystal display, light sources for instruments, a display panel, a navigation light, and the like.
Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.
The documents described in the specification are incorporated herein by reference in its entirety.

## Claims

1. An organic luminescent medium comprising an anthracene derivative represented by the following formula (1) and a compound having at least one electron-attracting group in the molecular structure thereof:

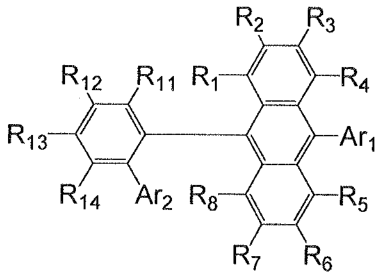

(1)

wherein $R_1$ to $R_8$ and $R_{11}$ to $R_{14}$ are independently a hydrogen atom, a fluorine atom, a substituted or unsubstituted alkyl group having 1 to 10 carbon atoms, a substituted or unsubstituted cycloalkyl group having 3 to 10 ring carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms, and

$Ar_1$ and $Ar_2$ are independently a substituted or unsubstituted aryl group having 6 to 30 ring carbon atoms or a substituted or unsubstituted heterocyclic group having 5 to 30 ring atoms.

2. The organic luminescent medium according to claim 1 wherein the compound having at least one electron-attracting group is a compound represented by the following formula (2):

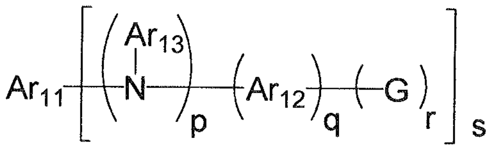

(2)

wherein $Ar_{11}$ is a substituted or unsubstituted anthracene-containing group, a substituted or unsubstituted pyrene-containing group, a substituted or unsubstituted chrysene-containing group, a substituted or unsubstituted benzofluoranthene-containing group or a substituted or unsubstituted styryl-containing group,

$Ar_{12}$ and $Ar_{13}$ are independently a substituted or unsubstituted aryl group having 6 to 30 ring carbon atoms or a substituted or unsubstituted heterocyclic group having 5 to 30 ring atoms,

G is an electron-attracting group,

p and q are independently an integer of 0 or 1, r is an integer of 1 to 5 and s is an integer of 1 to 6, and

if p and q are 0, r is 1, and if p is 1, q is 1.

3. The organic luminescent medium according to claim 2 wherein the compound represented by the formula (2) is one of the compounds represented by the following formulas (3) to (8):

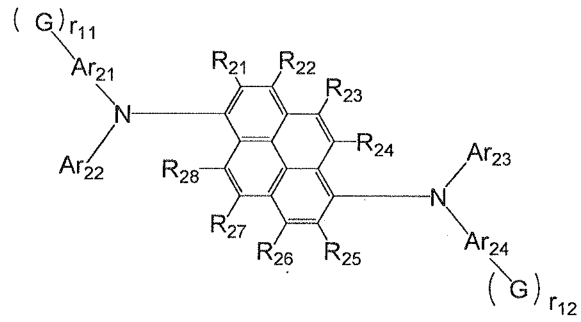

(3)

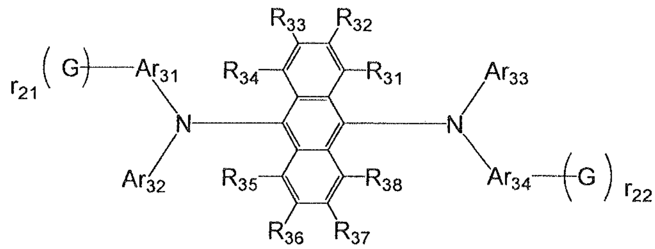

(4)

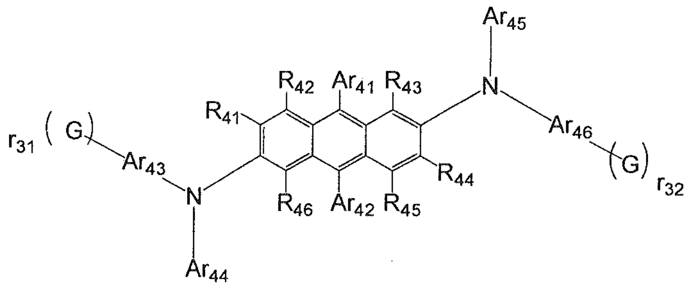

(5)

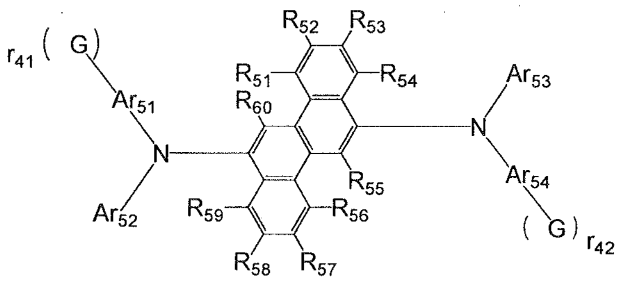

(6)

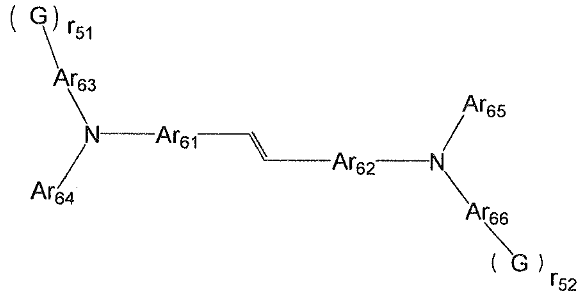

(7)

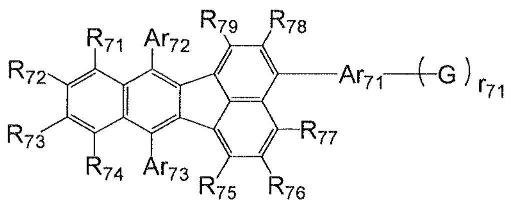

(8)

wherein $R_{21}$ to $R_{28}$, $R_{31}$ to $R_{38}$, $R_{41}$ to $R_{46}$, $R_{51}$ to $R_{60}$ and $R_{71}$ to $R_{79}$ are independently a hydrogen atom, a fluorine atom, a substituted or unsubstituted alkyl group having 1 to 10 carbon atoms, a substituted or unsubstituted cycloalkyl group having 3 to 10 ring carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,
$Ar_{21}$ to $Ar_{24}$, $Ar_{31}$ to $Ar_{34}$, $Ar_{41}$ to $Ar_{46}$, $Ar_{51}$ to $Ar_{54}$, $Ar_{61}$ to $Ar_{66}$, and $Ar_{71}$ to $Ar_{73}$ are independently a substituted or unsubstituted aryl group having 6 to 30 ring carbon atoms or a substituted or unsubstituted heterocyclic group having 5 to 30 ring atoms,
G is an electron-attracting group,
$r_{11}$, $r_{12}$, $r_{21}$, $r_{22}$, $r_{31}$. $r_{32}$, $r_{41}$, $r_{42}$, $r_{51}$, $r_{52}$ and $r_{71}$ are independently an integer of 1 to 5, and when two or more Gs are in one compound, they may be the same or different.

**4.** The organic luminescent medium according to any one of claims 1 to 3 wherein the electron-attracting group is a cyano group.

**5.** The organic luminescent medium according to any one of claims 1 to 4 wherein $Ar_1$ in the anthracene derivative represented by the formula (1) is a fused aromatic ring group having 10 to 30 ring carbon atoms.

**6.** The organic luminescent medium according to any one of claims 1 to 4 wherein the anthracene derivative represented by the formula (1) is represented by the following formula (10):

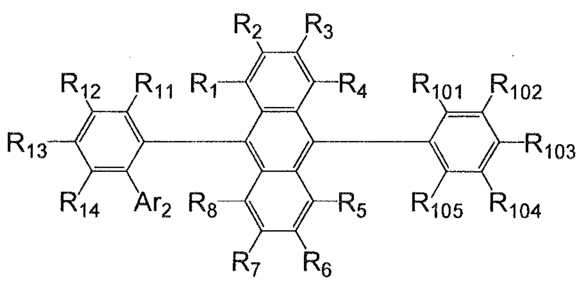

(10)

wherein $R_1$ to $R_8$, $R_{11}$ to $R_{14}$ and $Ar_2$ are the same as defined in claim 1, and $R_{101}$ to $R_{105}$ are independently a hydrogen atom, a fluorine atom, a substituted or unsubstituted alkyl group having 1 to 10 carbon atoms, a substituted

or unsubstituted cycloalkyl group having 3 to 10 ring carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms.

**7.** The organic luminescent medium according to claim 6 wherein the anthracene derivative represented by the formula (1) is represented by the following formula (11):

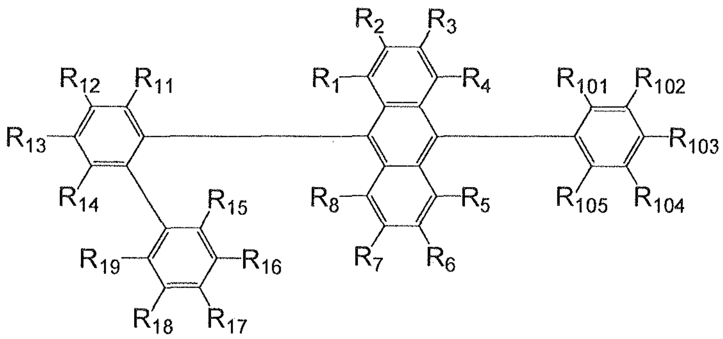

(11)

wherein $R_1$ to $R_8$, $R_{11}$ to $R_{14}$ and $R_{101}$ to $R_{105}$ are the same as defined in claim 6, and
$R_{15}$ to $R_{19}$ are independently a hydrogen atom, a fluorine atom, a substituted or unsubstituted alkyl group having 1 to 10 carbon atoms, a substituted or unsubstituted cycloalkyl group having 3 to 10 ring carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms.

**8.** The organic luminescent medium according to claim 6 or 7 wherein one of $R_{101}$ to $R_{105}$ is a substituted or unsubstituted aryl group having 6 to 30 ring carbon atoms or a substituted or unsubstituted heterocyclic group having 5 to 30 ring atoms, and the remaining $R_{101}$ to $R_{105}$ are all hydrogen atoms.

**9.** An organic thin film comprising the organic luminescent medium according to any one of claims 1 to 8.

**10.** An organic electroluminescence device comprising one or more organic thin film layers comprising at least an emitting layer between an anode and a cathode wherein at least one layer of the organic thin film layers is the organic thin film according to claim 9.

**INTERNATIONAL SEARCH REPORT**

International application No.
PCT/JP2010/007271

A. CLASSIFICATION OF SUBJECT MATTER
*H01L51/50*(2006.01)i, *C09K11/06*(2006.01)i

According to International Patent Classification (IPC) or to both national classification and IPC

B. FIELDS SEARCHED

Minimum documentation searched (classification system followed by classification symbols)
H01L51/50, C09K11/06

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
CA/REGISTRY(STN)

C. DOCUMENTS CONSIDERED TO BE RELEVANT

| Category* | Citation of document, with indication, where appropriate, of the relevant passages | Relevant to claim No. |
|---|---|---|
| P,X | JP 2010-111621 A (Sony Corp.), 20 May 2010 (20.05.2010), claims; paragraphs [0062] to [0072] (particularly, general formulae IIa, IId); paragraphs [0197] to [0200](particularly, chemical formulae 21, 22); examples (particularly, Organic Electroluminescent Element(no.1)) & US 2010/0109555 A1 & CN 101735107 A | 1,2,4,5,9,10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 02 March, 2011 (02.03.11) | 15 March, 2011 (15.03.11) |
| Name and mailing address of the ISA/ Japanese Patent Office | Authorized officer |
| Facsimile No. | Telephone No. |

Form PCT/ISA/210 (second sheet) (July 2009)

**INTERNATIONAL SEARCH REPORT**

International application No.
PCT/JP2010/007271

C (Continuation). DOCUMENTS CONSIDERED TO BE RELEVANT

| Category* | Citation of document, with indication, where appropriate, of the relevant passages | Relevant to claim No. |
|---|---|---|
| A | WO 2008/150942 A1 (E.I.DUPONT DE NEMOURS AND CO.), 11 December 2008 (11.12.2008), claims (particularly, compounds B1 to B9); page 13, line 27 to page 15, line 14 (particularly, H1, H2) & US 2008/0303430 A1 & CN 101679208 A & KR 10-2010-0017934 A | 1-10 |
| A | WO 2008/150940 A1 (E.I.DUPONT DE NEMOURS AND CO.), 11 December 2008 (11.12.2008), claims (particularly, formulae I, H1, H2); examples (particularly, example 1) & US 2008/0303428 A1 & CN 101679853 A & KR 10-2010-0024451 A | 1-10 |
| A | JP 2000-351965 A (Fuji Photo Film Co., Ltd.), 19 December 2000 (19.12.2000), claims; paragraphs [0098] to [0106]; examples & US 6537687 B1 & US 2003/0170494 A1 | 1-10 |
| A | WO 2002/038524 A1 (Idemitsu Kosan Co., Ltd.), 16 May 2002 (16.05.2002), claims; page 13, line 48 to page 22, line 30 (particularly, general formulae (10), (14) to (16), (30), (31)); examples (particularly, examples 26 to 28) & US 2004/0214035 A1 & US 2006/0083947 A1 & US 2008/0193799 A1 & EP 1333018 A1 & CN 1394195 A & KR 10-2008-0015953 A & KR 10-2008-0100272 A & KR 10-2008-0102237 A & CN 101381276 A | 1-10 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020070115588
- KR 1020080079956
- WO 2008102740 A
- WO 2005054162 A
- WO 2004018587 A